(19) Europäisches Patentamt
European Patent Office
Office européen des brevets

(11) **EP 3 435 172 B1**

(12) **FASCICULE DE BREVET EUROPEEN**

(45) Date de publication et mention
de la délivrance du brevet:
**24.11.2021 Bulletin 2021/47**

(51) Int Cl.:
***G04B 17/04*** *(2006.01)*      ***B81B 3/00*** *(2006.01)*
***G04B 31/02*** *(2006.01)*

(21) Numéro de dépôt: **18185139.5**

(22) Date de dépôt: **24.07.2018**

(54) **PROCEDE DE REALISATION D'UN MECANISME DE GUIDAGE FLEXIBLE POUR OSCILLATEUR MECANIQUE D'HORLOGERIE**

HERSTELLUNGSVERFAHREN EINES FLEXIBLEN FÜHRUNGSMECHANISMUS FÜR MECHANISCHEN OSZILLATOR EINES UHRWERKS

METHOD FOR PRODUCING A FLEXIBLE GUIDE MECHANISM FOR A TIMEPIECE MECHANICAL OSCILLATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **28.07.2017   EP 17183666**
          **25.06.2018   EP 18179623**

(43) Date de publication de la demande:
**30.01.2019   Bulletin 2019/05**

(73) Titulaire: **The Swatch Group Research and Development Ltd**
**2074 Marin (CH)**

(72) Inventeurs:
  • **Di Domenico, Gianni**
    **2000 Neuchâtel (CH)**
  • **Cusin, Pierre**
    **1423 Villars-Burquin (CH)**
  • **Helfer, Jean-Luc**
    **2525 Le Landeron (CH)**
  • **Gandelhman, Alex**
    **2000 Neuchâtel (CH)**
  • **Winkler, Pascal**
    **2072 St-Blaise (CH)**
  • **Hinaux, Baptiste**
    **1005 Lausanne (CH)**
  • **Léchot, Dominique**
    **2722 Les Reussilles (CH)**
  • **Matthey, Olivier**
    **1422 Grandson (CH)**
  • **Klinger, Laurent**
    **2503 Bienne (CH)**
  • **Favre, Jérôme**
    **2000 Neuchâtel (CH)**

(74) Mandataire: **ICB SA**
**Faubourg de l'Hôpital, 3**
**2001 Neuchâtel (CH)**

(56) Documents cités:
**EP-A1- 2 911 012          EP-A1- 3 326 963**
**EP-A2- 2 998 800          WO-A1-2016/124436**
**DE-A1-102016 014 001**

**Description**

Domaine de l'invention

L'invention concerne un procédé de réalisation d'un mécanisme de guidage flexible pour oscillateur mécanique comportant au moins un élément inertiel massif agencé pour osciller dans un plan d'oscillation, ledit guidage flexible comportant au moins deux premières lames flexibles s'étendant dans des plans parallèles ou confondus et chacune de section sensiblement rectangulaire et agencée pour être fixée ou encastrée sur un support fixe et supporter ledit élément inertiel massif, et agencées ensemble pour le rappeler vers une position de repos.

L'invention concerne le domaine des oscillateurs mécaniques d'horlogerie comportant des guidages à lames flexibles assurant les fonctions de maintien et de rappel d'éléments mobiles.

Arrière-pian de l'invention

L'utilisation de guidages flexibles, notamment à lames souples, dans des oscillateurs mécaniques d'horlogerie, est rendue possible par des procédés d'élaboration, tels que « MEMS », « LIGA » ou similaires, de matériaux microusinables, tels que le silicium et ses oxydes, qui permettent une fabrication très reproductible de composants qui présentent des caractéristiques élastiques constantes dans le temps et une grande insensibilité aux agents extérieurs tels que température et humidité. Des pivots à guidage flexible, tels que décrits dans les demandes EP1419039 ou EP16155039 du même déposant, permettent notamment de remplacer le pivot d'un balancier classique, ainsi que le ressort-spiral qui lui est usuellement associé. La suppression des frottements de pivots permet d'augmenter substantiellement le facteur de qualité d'un oscillateur. Toutefois les pivots à guidage flexible ont généralement une course angulaire faible, de l'ordre de 10° à 20°, ce qui est très faible en comparaison de l'amplitude usuelle de 300° d'un balancier-spiral, et qui n'autorise pas leur combinaison directe avec des mécanismes d'échappement classiques, et notamment avec des arrêtoirs usuels tels qu'une ancre suisse ou similaire, qui exigent une grande course angulaire pour assurer leur bon fonctionnement.

Lors du Congrès de Chronométrie de Montreux, Suisse, des 28 et 29 septembre 2016, l'équipe de M. H. Kahrobaiyan a abordé l'augmentation de cette course angulaire dans l'article « Gravity insensitive flexure pivots for watch oscillators », et il apparaît que la solution -complexe- envisagée n'est pas isochrone.

Le document EP3035127A1 au nom du même déposant SWATCH GROUP RESEARCH & DEVELOPMENT Ltd décrit un oscillateur d'horlogerie comportant une base de temps avec au moins un résonateur constitué par un diapason lequel comporte au moins deux parties mobiles oscillantes, lesdites parties mobiles étant fixées à un élément de liaison, que comporte ledit oscillateur, par des éléments flexibles dont la géométrie détermine un axe de pivotement virtuel de position déterminée par rapport audit élément de liaison, autour duquel axe de pivotement virtuel oscille ladite partie mobile respective, dont le centre de masse est confondu en position de repos avec ledit axe de pivotement virtuel respectif. Pour au moins une dite partie mobile, lesdits éléments flexibles sont constitués de lames élastiques croisées et s'étendant à distance l'une de l'autre dans deux plans parallèles, et dont les projections des directions sur un desdits plans parallèles se croisent au niveau dudit axe de pivotement virtuel, de ladite partie mobile considérée.

Le document US3628781A au nom de GRIB décrit une fourche de diapason, sous la forme d'une structure en porte-à-faux double, pour permettre un mouvement de rotation accentué d'une paire d'éléments mobiles, par rapport à un plan de référence fixe comprenant un premier corps élastiquement déformable ayant au moins deux parties flexibles allongées élastiquement similaires, les extrémités de chacune desdites parties flexibles étant respectivement solidaire de parties rigides agrandies dudit élément, la première desdites parties rigides étant fixée pour définir un plan de référence et la seconde étant supportée élastiquement pour avoir un mouvement de rotation accentué par rapport à la première, un second corps déformable élastiquement sensiblement identique au premier corps déformable élastiquement, et des moyens pour fixer rigidement les premières desdites parties rigides respectives desdits corps élastiquement déformables en relation espacée pour fournir une structure de fourche de diapason dans laquelle chacune des dents du diapason comprend l'extrémité libre de l'un desdits corps élastiquement déformables.

Le document EP2911012A1 au nom de CSEM décrit un oscillateur rotatif pour pièce d'horlogerie comprenant un élément de support destiné à permettre l'assemblage de l'oscillateur sur une pièce d'horlogerie, un balancier, une pluralité de lames flexibles reliant l'élément de support au balancier et aptes à exercer un couple de rappel sur le balancier, une serge montée solidaire du balancier, la pluralité de lames flexibles comportant au moins deux lames flexibles dont une première lame disposée dans un premier plan perpendiculaire au plan de l'oscillateur, et une deuxième lame disposée dans un deuxième plan perpendiculaire au plan de l'oscillateur et sécant avec le premier plan. Les première et deuxième lames sont de géométrie identique, et l'axe géométrique d'oscillation de l'oscillateur est défini par l'intersection du premier plan et du deuxième plan, cet axe géométrique d'oscillation croisant les première et deuxième lames aux 7/8ème de leur longueur respective.

Le document EP2998800A2 au nom de PATEK PHILIPPE décrit un composant horloger à pivot flexible, comprenant une première pièce monolithique définissant une première partie rigide et une deuxième partie rigide reliées par au moins une première lame élastique, et une deuxième pièce monolithique définissant une troisième partie rigide et une quatrième partie rigide reliées par au moins une deuxième lame élastique, les première et deuxième pièces monolithiques étant assemblées l'une à l'autre de telle sorte que les première et troisième parties rigides soient solidaires l'une de l'autre, les deuxième et quatrième parties rigides soient solidaires l'une de l'autre. La au moins une première lame élastique et la au moins une deuxième lame élastique se croisent sans contact et définissent un axe de rotation virtuel pour les deuxième et quatrième parties rigides, par rapport aux première et troisième parties rigides. Ce composant comprend un palier, solidaire des deuxième et quatrième parties rigides, et destiné à guider la rotation d'un élément mobile autour d'un axe distinct de l'axe de rotation virtuel et sensiblement parallèle à ce dernier.

Le document DE10 2016 014001 A1 au nom de BLICKFELD décrit un module de balayage pour un scanner de lumière, comprenant une base, un élément d'interface agencé pour être une surface de miroir et au moins un élément de support situé entre la base et l'élément d'interface et ayant une extension perpendiculaire à la surface du miroir non inférieure à 0,7 mm, la base, l'élément d'interface et le au moins un élément de support formant un ensemble monobloc. Plus particulièrement un élément de support est une tige longiligne déformable en flexion ou/et en torsion.

Le document EP3326963 au nom du même déposant SWATCH GROUP RESEARCH & DEVELOPMENT Ltd décrit un procédé de fabrication de lame flexible, consistant à constituer une plaque d'épaisseur requise par une ou plusieurs tranches de substrat micro-usinable, à apposer, de part et d'autre de la plaque, un masque supérieur à fenêtre supérieure, et un masque inférieur à fenêtre inférieure, de géométrie identique, à graver la plaque, au moins à mi-épaisseur, depuis le côté supérieur de chaque fenêtre supérieure, et depuis le côté de chaque fenêtre inférieure, puis à retirer le masque supérieur et le masque inférieur, pour délimiter une lame flexible de hauteur égale à l'épaisseur de la plaque, et dont les bords sont bruts de gravure. Il décrit encore une lame flexible en matériau micro-usinable, comportant, entre deux surfaces supérieure et inférieure parallèles, deux surfaces périphériques de chant en dépouille et en contre-dépouille, pour un pivot flexible, un résonateur, un mouvement, ou une montre.

Le document EP3130966A1 au nom de ETA Manufacture Horlogère Suisse décrit un mouvement d'horlogerie mécanique qui comprend au moins un barillet, un ensemble de roues d'engrenage entraîné à une extrémité par le barillet, et un mécanisme d'échappement d'un oscillateur local avec un résonateur sous forme d'un balancier-spiral et un système de rétroaction du mouvement d'horlogerie. Le mécanisme d'échappement est entraîné à une autre extrémité de l'ensemble de roues d'engrenage. Le système de rétroaction comprend au moins un oscillateur de référence précis, combiné à un comparateur de marche pour comparer la marche des deux oscillateurs, et un mécanisme de réglage du résonateur de l'oscillateur local pour ralentir ou accélérer le résonateur sur la base d'un résultat de la comparaison dans le comparateur de marche.

Le document CH709536A2 au nom de ETA Manufacture Horlogère Suisse décrit un mécanisme régulateur d'horlogerie comportant, montés mobiles, au moins en pivotement par rapport à une platine, une roue d'échappement agencée pour recevoir un couple moteur via un rouage, et un premier oscillateur comportant une première structure rigide reliée à ladite platine par des premiers moyens de rappel élastique. Ce mécanisme régulateur comporte un deuxième oscillateur comportant une deuxième structure rigide reliée à ladite première structure rigide par des deuxièmes moyens de rappel élastique, et qui comporte des moyens de guidage agencés pour coopérer avec des moyens de guidage complémentaire que comporte ladite roue d'échappement, synchronisant ledit premier oscillateur et ledit deuxième oscillateur avec ledit rouage.

La demande de brevet EP17183666 au nom du même déposant SWATCH GROUP RESEARCH & DEVELOPMENT Ltd décrit un pivot à grande course angulaire. En utilisant un angle entre les lames d'environ 25° à 30°, et un point de croisement situé à environ 45% de leur longueur, il est possible d'obtenir simultanément un bon isochronisme et une insensibilité aux positions sur une grande course angulaire (jusqu'à 40° ou plus). Afin de maximiser la course angulaire tout en conservant une bonne rigidité hors plan, on tend à affiner les lames tout en augmentant leur hauteur. L'utilisation d'une grande valeur du rapport d'aspect, c'est-à-dire du rapport entre la hauteur de la lame sur son épaisseur est théoriquement avantageuse, mais dans la pratique on rencontre souvent des phénomènes de courbure anticlastique, qui altèrent les propriétés.

Le document WO2016/124436A1 au nom de ETA Manufacture Horlogère Suisse décrit un mécanisme oscillateur monolithique doté de lames élastiques qui sont au moins cinq fois plus hautes qu'épaisses.

Résumé de l'invention

L'invention se propose de mettre au point un procédé de réalisation d'un mécanisme de guidage flexible pour oscillateur mécanique d'horlogerie, de façon à ce que sa course angulaire soit compatible avec des mécanismes d'échappement existants, et dont les guidages flexibles se comportent de façon régulière quelle que soit leur déformation.

Ce résonateur à guidage flexible en rotation doit posséder les propriétés suivantes :

- un facteur de qualité élevé ;

- une grande course angulaire ;
- un bon isochronisme ;
- une grande insensibilité aux positions dans l'espace.

Et il s'agit de réaliser un tel oscillateur de façon à garantir le maintien de l'isochronisme dans les positions extrêmes des lames flexibles qu'il comporte, et, à cet effet, de prévenir tout vrillage ou toute courbure anticlastique de ces lames.

A cet effet, l'invention concerne un procédé de réalisation d'un mécanisme de guidage flexible pour oscillateur mécanique d'horlogerie selon la revendication 1.

Description sommaire des dessins

D'autres caractéristiques et avantages de l'invention apparaîtront à la lecture de la description détaillée qui va suivre, en référence aux dessins annexés, où :

- la figure 1 représente, de façon schématisée, et en perspective, une première variante d'oscillateur mécanique, qui comporte un élément support rigide, de forme allongée, pour sa fixation à une platine du mouvement ou similaire, auquel est suspendu un élément inertiel massif par deux premières flexibles disjointes, croisées en projection sur le plan d'oscillation de cet élément inertiel, lequel coopère avec un mécanisme d'échappement classique avec ancre suisse et roue d'échappement standard ;
- la figure 2 représente, de façon schématisée, et en plan, l'oscillateur de la figure 1 ;
- la figure 3 représente, de façon schématisée, et en coupe passant par l'axe de croisement des lames, l'oscillateur de la figure 1 ;
- la figure 4 représente, de façon schématisée, un détail de la figure 2, montrant le décalage entre le croisement des lames et la projection du centre de masse du résonateur, ce détail avec décalage étant applicable de la même façon aux différentes variantes décrites ci-après;
- la figure 5 est un graphe, avec en abscisse rapport X= D/L entre, d'une part la distance D du point d'encastrement d'une lame dans la masse fixe et le point de croisement, et d'autre part la longueur totale L de cette même lame entre ses deux encastrements opposés, et en ordonnées l'angle au sommet de croisement des lames flexibles, et qui définit deux courbes, inférieure et supérieure, en trait interrompu, qui bornent le domaine convenable entre ces paramètres pour assurer l'isochronisme, la courbe en trait plein correspondant à une valeur avantageuse ;
- la figure 6 représente, de façon similaire à la figure 1, une deuxième variante d'oscillateur mécanique, où l'élément support rigide, de forme allongée, est aussi mobile par rapport à une structure fixe, et est porté par un troisième élément rigide, par l'intermédiaire d'un second jeu de lames flexibles, agencées de façon similaire au premières lames flexibles, l'élément inertiel étant encore agencé pour coopérer avec un mécanisme d'échappement classique non représenté ;
- la figure 7 représente, de façon schématisée, et en plan, l'oscillateur de la figure 6;
- la figure 8 représente, de façon schématisée, et en coupe passant par l'axe de croisement des lames, l'oscillateur de la figure 1 ;
- la figure 9 est un schéma-blocs représentant une montre qui comporte un mouvement avec un tel résonateur ;

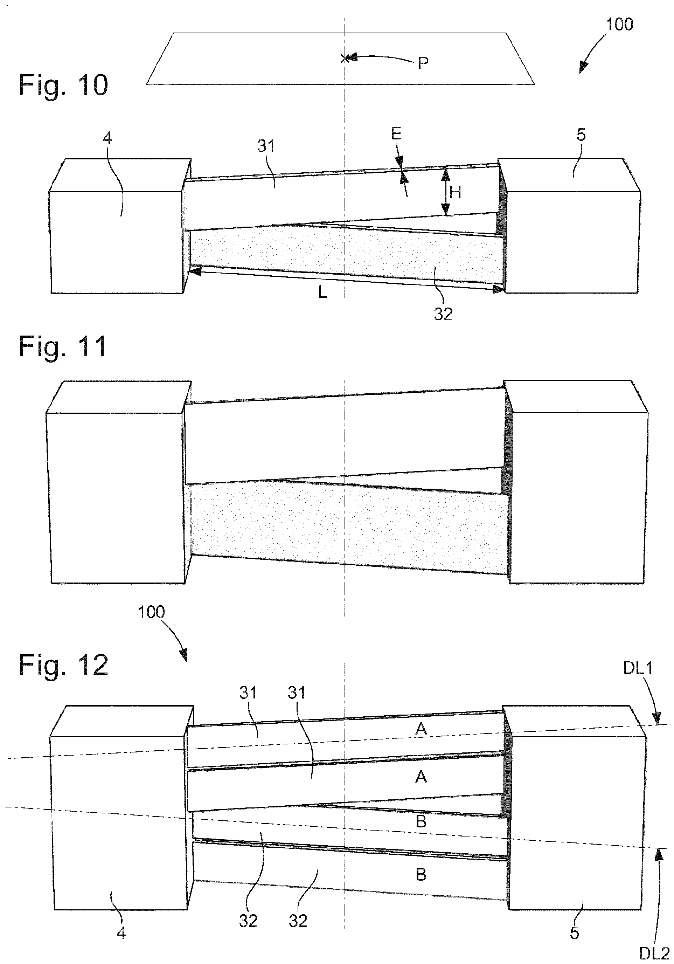

- la figure 10 représente, de façon schématisée et en perspective, un guidage à lames flexibles croisées en projection, entre une structure fixe et un élément inertiel ;
- la figure 11 représente, de façon similaire à la figure 10, un guidage flexible théorique dont chaque lame a un rapport d'aspect supérieur à celui des lames de la figure 10 ;
- la figure 12 représente, de façon similaire à la figure 10, un guidage flexible, équivalent en termes de rappel élastique au guidage théorique de la figure 11, mais comportant un nombre supérieur de lames, dont chacune a un rapport d'aspect inférieur à 10, dans cette variante deux lames élémentaires d'un premier type sont superposées dans une première direction, et croisent en projection deux lames élémentaires d'un deuxième type qui sont aussi superposées entre elles et s'étendent dans une deuxième direction ;

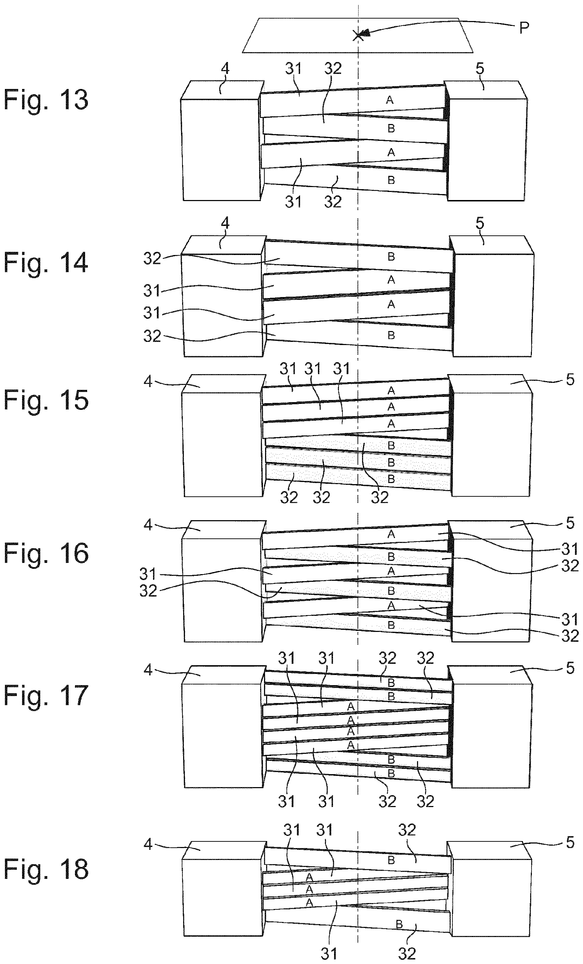

- la figure 13 représente, de façon similaire à la figure 12, un autre guidage flexible, dont les quatre lames sont en quinconce ;
- la figure 14 représente, de façon similaire à la figure 12, encore un autre guidage flexible, dont les quatre lames comportent deux lames élémentaires d'un premier type dans une première direction, qui encadrent deux lames élémentaires d'un deuxième type qui sont superposées entre elles et s'étendent dans une deuxième direction ;
- la figure 15 représente, de façon similaire à la figure 12, un autre guidage flexible, comportant six lames superposées par trois ;
- la figure 16 représente, de façon similaire à la figure 13, un autre guidage flexible, dont les six lames sont en quinconce ;

- la figure 17 représente, de façon similaire à la figure 14, un autre guidage flexible, dont les huit lames comportent une première et une deuxième superposition de deux lames élémentaires d'un premier type dans une première direction, qui encadrent quatre lames élémentaires d'un deuxième type qui sont superposées entre elles et s'étendent dans une deuxième direction ;
- la figure 18 représente, de façon similaire à la figure 12, encore un autre guidage flexible, à nombre inégal de lames, dont les cinq lames comportent deux lames élémentaires d'un premier type dans une première direction, qui encadrent trois lames élémentaires d'un deuxième type qui sont superposées entre elles et s'étendent dans une deuxième direction ;
- la figure 19 est identique à la figure 13, et la figure 20 montre la décomposition de ce guidage flexible à quatre lames alternées en deux sous-unités de pivots à deux lames ;
- la figure 21 est identique à la figure 14, et la figure 22 montre la décomposition de ce guidage flexible à quatre lames encadrées en deux sous-unités de pivots à deux lames ;
- la figure 23 représente, de façon schématisée, et, ramenés dans le même plan, la partie supérieure et la partie inférieure d'un oscillateur avec un tel guidage flexible décomposé en plusieurs sous-unités, dans le cas d'espèce un étage supérieur et un étage inférieur, avec des tables de translation interposées entre le support fixe et l'appui des lames vers l'élément inertiel, ces tables de translation comportant des guidages élastiques souples selon les directions X et Y des bissectrices aux directions en projection des lames ;
- la figure 24 est similaire à la figure 23, et comporte un réglage de position en X sur une partie rigide inférieure, de façon à modifier l'écart entre les projections des croisements des lames supérieures et inférieures ;
- les figures 25 à 27 illustrent d'autres variantes de tables de translation ;
- la figure 28 représente, de façon schématisée, et en vue de côté, la partie supérieure et la partie inférieure d'un oscillateur avec un guidage flexible décomposé en deux sous-unités, dans le cas d'espèce un étage supérieur et un étage inférieur, avec une table de translation interposée entre le support fixe et l'appui supérieur des lames supérieures vers l'élément inertiel ;

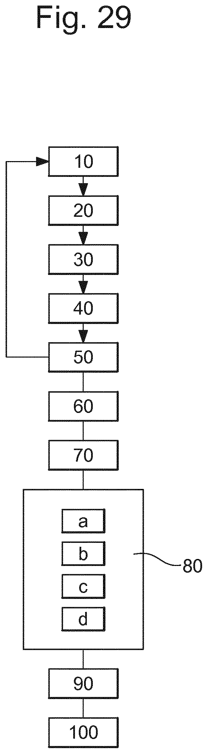

- la figure 29 est un logigramme représentant les étapes d'un procédé de réalisation d'un guidage flexible selon l'invention.

## Description détaillée des modes de réalisation préférés

L'invention concerne la réalisation d'un oscillateur mécanique 100 d'horlogerie, comportant au moins un élément support rigide 4 fixé directement ou indirectement sur une platine 900, et un élément inertiel massif 5. Cet oscillateur 100 comporte, entre l'élément support rigide 4 et l'élément inertiel massif 5, un mécanisme de guidage flexible 200. Ce mécanisme de guidage flexible comporte au moins deux premières lames flexibles 31, 32, qui supportent l'élément inertiel massif 5 et sont agencées pour le rappeler vers une position de repos. Cet élément inertiel massif 5 est agencé pour osciller angulairement selon un plan d'oscillation autour de cette position de repos.

Les deux premières lames flexibles 31 et 32 ne se touchent pas, et, en position de repos, leurs projections sur le plan d'oscillation se croisent en un point de croisement P, au voisinage immédiat duquel ou par lequel passe l'axe de rotation de l'élément inertiel massif 5 perpendiculairement au plan d'oscillation. Tous les éléments géométriques décrits ci-après s'entendent, sauf mention contraire, comme étant considérés dans la position de repos de l'oscillateur à l'arrêt.

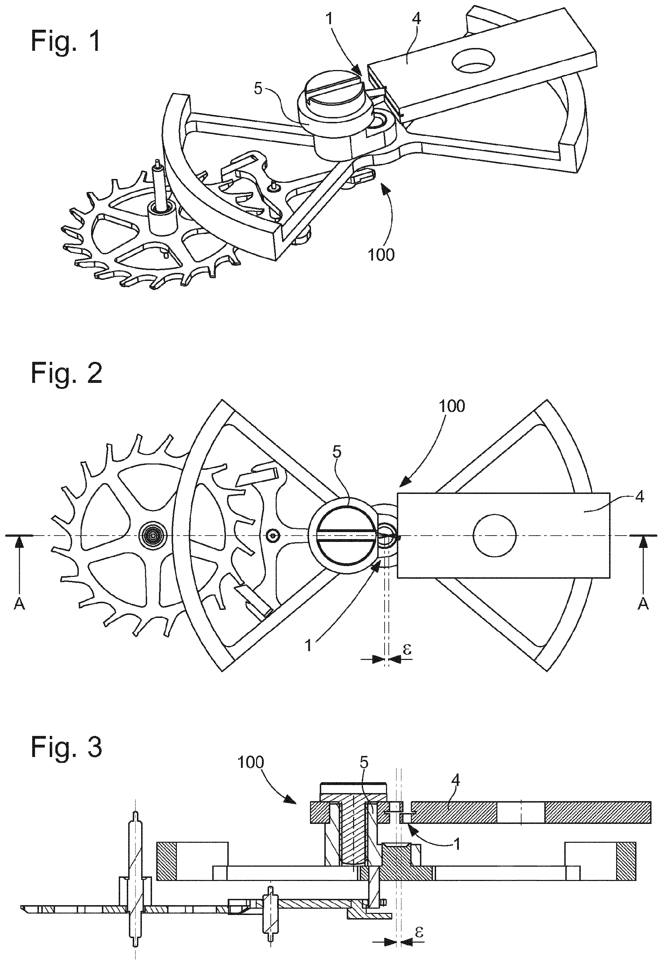

Les figures 1 à 4 illustrent une première variante avec un élément support rigide 4 et un élément inertiel massif reliés par deux premières lames flexibles 31, 32.

Les encastrements des premières lames flexibles 31, 32, avec l'élément support rigide 4 et l'élément inertiel massif 5 définissent au moins deux directions de lames DL1, DL2, qui sont parallèles au plan d'oscillation et qui font entre elles, en projection sur le plan d'oscillation, un angle au sommet a.

La position du point de croisement P est définie par le rapport $X = D/L$ où D est la distance entre la projection, sur le plan d'oscillation, de l'un des points d'encastrement des premières lames 31, 32, dans le premier élément de support rigide 4 et le point de croisement P, et où L est la longueur totale de la projection, sur le plan d'oscillation, de la lame 31, 32, concernée. Et la valeur du rapport $D/L$ est comprise entre 0 et 1, et l'angle au sommet $\alpha$ est inférieur ou égal à 70°.

De façon avantageuse, à la fois l'angle au sommet $\alpha$ est inférieur ou égal à 60°, et, pour chaque première lame flexible 31, 32, le rapport d'encastrement $D1/L1$, $D2/L2$, est compris entre 0.15 et 0.85, bornes comprises.

De façon particulière, tel que visible sur les figures 2 à 4, le centre de masse de l'oscillateur 100 dans sa position de repos est distant du point de croisement P d'un écart $\varepsilon$ qui est compris entre 10% et 20% de la longueur totale L de la projection, sur le plan d'oscillation, de la lame 31, 32. Plus particulièrement encore, l'écart $\varepsilon$ est compris entre 12% et 18% de la longueur totale L de la projection, sur le plan d'oscillation, de la lame 31, 32.

Plus particulièrement, et tel qu'illustré sur les figures, les premières lames 31, 32, et leurs encastrements définissent ensemble un pivot 1 qui, en projection sur le plan d'oscillation, est symétrique par rapport à un axe de symétrie AA passant par le point de croisement P.

Plus particulièrement, quand le pivot 1 est symétrique par rapport à l'axe de symétrie AA, en position de repos, en projection sur le plan d'oscillation, le centre de masse de l'élément inertiel massif 5 est situé sur l'axe de symétrie AA du pivot 1. En projection, ce centre de masse peut être confondu ou non avec le point de croisement P.

Plus particulièrement encore, le centre de masse de l'élément inertiel massif 5 est situé à une distance non nulle du point de croisement P correspondant à l'axe de rotation de l'élément inertiel massif 5, tel que visible sur les figures 2 à 4.

De façon particulière, en projection sur le plan d'oscillation, le centre de masse de l'élément inertiel massif 5 est situé sur l'axe de symétrie AA du pivot 1, et est situé à distance non nulle du point de croisement P laquelle est comprise entre 0.1 fois et 0.2 fois la longueur totale L de la projection, sur le plan d'oscillation, de la lame 31, 32.

Plus particulièrement, les premières lames 31 et 32 sont des lames droites.

Plus particulièrement encore, l'angle au sommet $\alpha$ est inférieur ou égal à 50°, ou encore est inférieur ou égal à 40°, ou encore inférieur ou égal à 35°, ou encore inférieur ou égal à 30°.

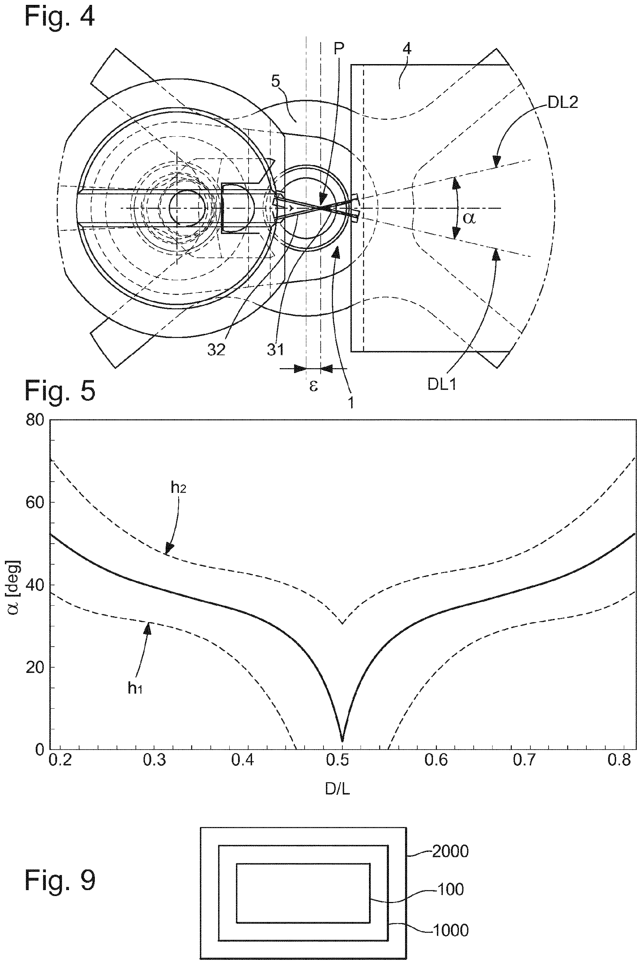

Plus particulièrement, le rapport d'encastrement D1/L1, D2/L2, est compris entre 0.15 et 0.49, bornes comprises, ou entre 0.51 et 0.85, bornes comprises, tel que visible sur la figure 5.

Dans une variante, et plus particulièrement selon l'exécution selon la figure 5, l'angle au sommet $\alpha$ est inférieur ou égal à 50°, et le rapport d'encastrement D1/L1, D2/L2, est compris entre 0.25 et 0.75, bornes comprises.

Dans une variante, et plus particulièrement selon l'exécution selon la figure 5, l'angle au sommet $\alpha$ est inférieur ou égal à 40°, et le rapport d'encastrement D1/L1, D2/L2, est compris entre 0.30 et 0.70, bornes comprises.

Dans une variante, et plus particulièrement selon l'exécution selon la figure 5, l'angle au sommet $\alpha$ est inférieur ou égal à 35°, et le rapport d'encastrement D1/L1, D2/L2, est compris entre 0.40 et 0.60, bornes comprises.

De façon avantageuse, et tel que visible sur la figure 5, l'angle au sommet $\alpha$ et le rapport X= D/L satisfont la relation :

$$h1(D/L) < a < h2(D/L), \text{ avec,}$$
$$\text{pour } 0.2 \leq X < 0.5 :$$

$$h1(X)= 116 - 473*(X + 0.05) + 3962*(X + 0.05)^3 - 6000*(X + 0.05)^4,$$
$$h2(X)=128 - 473*(X - 0.05) + 3962*(X - 0.05)^3 - 6000*(X - 0.05)^4,$$
$$\text{pour } 0.5 < X \leq 0.8:$$

$$h1(X)= 116 - 473*(1.05 - X) + 3962*(1.05 - X)^3 - 6000*(1.05 - X)^4,$$
$$h2(X)=128 - 473*(0.95 - X) + 3962*(0.95 - X)^3 - 6000*(0.95 - X)^4.$$

Plus particulièrement, et notamment dans l'exécution non limitative illustrée par les figures, les premières lames flexibles 31 et 32 ont la même longueur L, et la même distance D.

Plus particulièrement, entre leurs encastrements, ces premières lames flexibles 31 et 32 sont identiques.

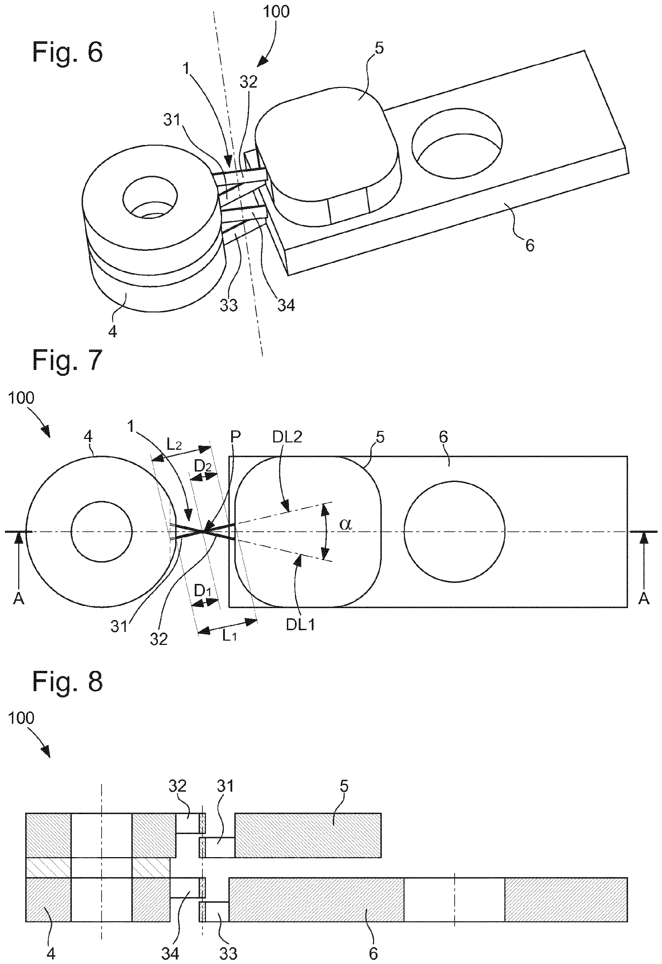

Les figures 6 à 8 illustrent une deuxième variante d'oscillateur mécanique 100, où l'élément support rigide 4 est aussi mobile, directement ou indirectement par rapport à une structure fixe que comporte cet oscillateur 100, et est porté par un troisième élément rigide 6, par l'intermédiaire de deux secondes lames flexibles 33, 34, agencées de façon similaire au premières lames flexibles 31, 32.

Plus particulièrement, dans la réalisation non limitative illustré par les figures, les projections des premières lames flexibles 31, 32, et des secondes lames flexibles 33, 34, sur le plan d'oscillation se croisent au même point de croisement P.

Dans une autre forme particulière d'exécution non illustrée, en position de repos, en projection sur le plan d'oscillation, les projections des premières lames flexibles 31, 32, et des secondes lames flexibles 33, 34, sur le plan d'oscillation se croisent en deux points distincts tous deux situés sur l'axe de symétrie AA du pivot 1, quand le pivot 1 est symétrique par rapport à l'axe de symétrie AA.

Plus particulièrement, les encastrements des secondes lames flexibles 33, 34, avec l'élément support rigide 4 et le troisième élément rigide 6, définissent deux directions de lames parallèles au plan d'oscillation et faisant entre elles, en projection sur le plan d'oscillation, un angle au sommet de même bissectrice que l'angle au sommet $\alpha$ que les premières lames flexibles 31, 32. Plus particulièrement encore, ces deux directions des secondes lames flexibles 33, 34, présentent le même angle au sommet $\alpha$ que les premières lames flexibles 31, 32.

Plus particulièrement, les secondes lames flexibles 33, 34, sont identiques aux premières lames flexibles 31, 32, comme dans l'exemple non limitatif des figures.

Plus particulièrement, quand le pivot 1 est symétrique par rapport à l'axe de symétrie AA, en position de repos, en projection sur le plan d'oscillation, le centre de masse de l'élément inertiel massif 5 est situé sur l'axe de symétrie AA du pivot 1.

De façon similaire et particulière, quand le pivot 1 est symétrique par rapport à l'axe de symétrie AA, en position de repos, le centre de masse de l'élément support rigide 4 est situé, en projection sur le plan d'oscillation, sur l'axe de symétrie AA du pivot 1.

Dans une variante particulière, quand le pivot 1 est symétrique par rapport à l'axe de symétrie AA, en position de repos, en projection sur le plan d'oscillation, à la fois le centre de masse du élément inertiel massif 5 et le centre de masse du élément support rigide 4 sont situés sur l'axe de symétrie AA du pivot 1. Plus particulièrement encore, les projections du centre de masse de l'élément inertiel massif 5 et du centre de masse de l'élément support rigide 4, sur l'axe de symétrie AA du pivot 1, sont confondues.

Une configuration particulière illustrée par les figures pour de tels pivots superposés est celle où les projections des premières lames flexibles 31, 32, et des secondes lames flexibles 33, 34, sur le plan d'oscillation se croisent au même point de croisement P, qui correspond aussi à la projection du centre de masse de l'élément inertiel massif 5, ou du moins qui en est la plus proche possible. Plus particulièrement ce même point correspond aussi à la projection du centre de masse de l'élément support rigide 4. Plus particulièrement encore, ce même point correspond aussi à la projection du centre de masse de l'oscillateur 100 tout entier.

Dans une variante particulière de cette configuration de pivots superposés, quand le pivot 1 est symétrique par rapport à l'axe de symétrie AA, en position de repos, en projection sur le plan d'oscillation, le centre de masse de l'élément inertiel massif 5 est situé sur l'axe de symétrie AA du pivot 1, et à une distance non nulle du point de croisement correspondant à l'axe de rotation de l'élément inertiel massif 5, laquelle distance non nulle est comprise entre 0.1 fois et 0.2 fois la longueur totale L de la projection, sur le plan d'oscillation, de la lame 33, 34, avec un écart similaire à l'écart ε des figures 2 à 4.

De façon similaire et particulière, quand le pivot 1 est symétrique par rapport à l'axe de symétrie AA, le centre de masse de l'élément inertiel massif 5 est situé, en projection sur le plan d'oscillation, sur l'axe de symétrie AA du pivot 1 et à une distance non nulle du point de croisement correspondant à l'axe de rotation de l'élément support rigide 4 laquelle distance non nulle est comprise entre 0.1 fois et 0.2 fois la longueur totale L de la projection, sur le plan d'oscillation, de la lame 31, 32.

De façon similaire et particulière, quand le pivot 1 est symétrique par rapport à l'axe de symétrie AA, le centre de masse de l'élément support rigide 4 est situé, en projection sur le plan d'oscillation, sur l'axe de symétrie AA du pivot 1 et à une distance non nulle du point de croisement P correspondant à l'axe de rotation de l'élément inertiel massif 5. Notamment cette distance non nulle est comprise entre 0.1 fois et 0.2 fois la longueur totale L de la projection, sur le plan d'oscillation, de la lame 33, 34.

De façon similaire et particulière, quand le pivot 1 est symétrique par rapport à l'axe de symétrie AA, le centre de masse de l'élément support rigide 4 est situé, en projection sur le plan d'oscillation, sur l'axe de symétrie AA du pivot 1 et à une distance non nulle du point de croisement correspondant à l'axe de rotation de l'élément support rigide 4 laquelle distance non nulle est comprise entre 0.1 fois et 0.2 fois la longueur totale L de la projection, sur le plan d'oscillation, de la lame 31, 32.

De façon similaire et particulière, le centre de masse de l'élément support rigide 4 est situé sur l'axe de symétrie AA du pivot 1 et à la distance non nulle du point de croisement P laquelle est comprise entre 0.1 fois et 0.2 fois la longueur totale L de la projection, sur le plan d'oscillation, de la lame 33, 34.

Plus particulièrement, et tel que visible sur la variante des figures, quand le pivot 1 est symétrique par rapport à l'axe de symétrie AA, en projection sur le plan d'oscillation, le centre de masse de l'oscillateur 100 dans sa position de repos est situé sur l'axe de symétrie AA.

Plus particulièrement, l'élément inertiel massif 5 est allongé selon la direction de l'axe de symétrie AA du pivot 1, quand le pivot 1 est symétrique par rapport à l'axe de symétrie AA. C'est par exemple le cas des figures1 à 4 où l'élément inertiel 5 comporte une embase sur laquelle est fixé un balancier traditionnel à bras longs pourvus de tronçons de serge ou de masselottes en arc de cercle. L'objectif est de minimiser l'influence des accélérations angulaires externes autour de l'axe de symétrie du pivot, car les lames ont une faible rigidité en rotation autour de cet axe à cause du petit angle a.

L'invention se prête bien à une exécution monolithique des lames et des composants massifs qu'elles joignent, en matériau micro-usinable ou au moins partiellement amorphe, avec une mise en œuvre par procédé « MEMS » ou « LIGA » ou similaire. En particulier, dans le cas d'une exécution en silicium, l'oscillateur 100 est avantageusement compensé thermiquement par ajout de dioxyde de silicium sur des lames flexibles en silicium. Dans une variante, les lames peuvent être assemblées, par exemple encastrées dans des rainures, ou autre.

Lorsque on a deux pivots en série, comme dans le cas de figures 6 à 9, on peut mettre le centre de masse sur l'axe de rotation, dans le cas où l'agencement est choisi pour que les déplacements parasites se compensent, ce qui constitue une variante avantageuse mais non limitative. Il convient toutefois de remarquer qu'il n'est pas nécessaire de choisir un tel agencement, et un tel oscillateur fonctionne avec deux pivots en série sans pour autant positionner le centre de masse sur l'axe de rotation. Bien sûr, même si les réalisations illustrées correspondent à des configurations géométriques particulières d'alignement, ou de symétrie, on comprend qu'il est aussi possible d'empiler deux pivots différents, ou avec des points de croisement différents, ou avec des centres de masses non alignés, ou encore de mettre en œuvre un nombre supérieur de jeux de lames en série, avec des masses intermédiaires, pour augmenter encore l'amplitude du balancier.

Les variantes illustrées comportent tous les axes de pivotement, croisements de lames, et centres de masse, coplanaires, ce qui est un cas particulier avantageux, mais non limitatif.

On comprend qu'il est ainsi possible d'obtenir une course angulaire qui est grande: en tous les cas supérieure à 30°, elle peut même atteindre 50° voire 60°, ce qui la rend compatible en combinaison avec tous les échappements mécaniques usuels, ancre suisse, détente, co-axial, ou autre.

Il s'agit, encore, de déterminer une solution pratique qui soit équivalente à l'utilisation théorique d'une grande valeur du rapport d'aspect des lames.

A cet effet, il est avantageux de subdivises les lames dans le sens de la longueur, en substituant à une lame unique une pluralité de lames élémentaires dont le comportement global soit équivalent, et où chacune des lames élémentaires a un rapport d'aspect limité à une valeur seuil. On diminue ainsi, par rapport à une lame unique de référence, le rapport d'aspect de chaque lame élémentaire, pour retrouver l'optimum d'isochronisme et d'insensibilité aux positions.

Chaque lame 31, 32, a un rapport d'aspect $RA = H/E$, où H est la hauteur de la lame 31, 32, perpendiculairement à la fois au plan d'oscillation et à l'élongation de la lame 31, 32, selon la longueur L, et où E est l'épaisseur de la lame 31, 32, dans le plan d'oscillation et perpendiculairement à l'élongation de la lame 31, 32, selon la longueur L.

De façon préférée, le rapport d'aspect $RA = H/E$ est inférieur à 10 pour chaque lame 31, 32. Plus particulièrement ce rapport d'aspect est inférieur à 8. Et le nombre total des lames flexibles 31, 32, est strictement supérieur à deux.

Plus particulièrement, l'oscillateur 100 comporte un premier nombre N1 de premières lames appelées lames primaires 31 s'étendant selon une première direction de lame DL1, et un deuxième nombre N2 de premières lames secondaires 32 s'étendant selon une deuxième direction de lame DL2, le premier nombre N1 et le deuxième nombre N2 étant chacun supérieur ou égal à deux.

Plus particulièrement, le premier nombre N1 est égal au deuxième nombre N2.

Plus particulièrement encore, l'oscillateur 100 comporte au moins une paire formée d'une lame primaire 31 s'étendant selon une première direction de lame DL1, et d'une lame secondaire 32 s'étendant selon une deuxième direction de lame DL2. Et, dans chaque paire, la lame primaire 31 est identique à la lame secondaire 32 à l'orientation près.

Dans une variante particulière, l'oscillateur 100 ne comporte que des paires chacune formée d'une lame primaire 31 s'étendant selon une première direction de lame DL1, et d'une lame secondaire 32 s'étendant selon une deuxième direction de lame DL2, et, dans chaque paire, la lame primaire 31 est identique à la lame secondaire 32 à l'orientation près.

Dans une autre variante, l'oscillateur 100 comporte au moins un groupe de lames formé d'une lame primaire 31 s'étendant selon une première direction de lame DL1, et d'une pluralité de lames secondaires 32 s'étendant selon une deuxième direction de lame DL2. Et, dans ce cas, dans chaque groupe de lames, le comportement élastique de la lame primaire 31 est identique au comportement élastique résultant du cumul de la pluralité de lames secondaires 32 à l'orientation près.

On remarque encore que, si le comportement d'une lame flexible dépend de son rapport d'aspect RA, il dépend également de la valeur de la courbure qui lui est imprimée. Sa déformée dépend à la fois de la valeur du rapport d'aspect et de la valeur locale du rayon de courbure, notamment à l'encastrement. C'est la raison pour laquelle on adopte, de préférence, une disposition des lames en symétrie en projection plane.

L'invention concerne encore la réalisation d'un mouvement d'horlogerie 1000 comportant au moins un tel oscillateur 100 mécanique.

L'invention concerne encore la réalisation d'une montre 2000 comportant au moins un tel mouvement d'horlogerie 1000.

Un procédé de fabrication convenable consiste à effectuer, pour les différents types de pivots ci-dessous, les opérations suivantes :

Pour un type de pivot AABB :

a. utiliser un substrat avec au moins quatre couches, résultant par exemple mais non limitativement de l'assemblage de deux wafers SOI ;

b. graver par procédé de gravure "DRIE" face avant pour obtenir AA, avec notamment gravure des deux couches d'un seul tenant ;

c. graver par procédé de gravure "DRIE" face arrière pour obtenir BB, avec notamment gravure des deux couches d'un seul tenant ;

d. effectuer la séparation partielle des quatre couches par gravure de l'oxyde enterré.

La grande précision du procédé "DRIE", c'est-à-dire gravure ionique réactive profonde (en anglais Deep Reactive Ion Etching DRIE) garantit une très bonne précision en positionnement et en alignement, inférieure ou égale à 5 micromètres, grâce à un alignement optique, ce qui garantit un très bon alignement face à face. Naturellement des procédés équivalents peuvent être mis en œuvre selon le matériau choisi.

Il est possible de mettre en œuvre des substrats avec un nombre supérieur de couches, notamment un substrat à six couches disponibles, par exemple par assemblage de deux DSOI, pour obtenir une structure de type AAABBB.

Une variante pour l'obtention d'un même type de pivot AABB consiste à :

a. utiliser deux substrats SOI standard à deux couches ;
b. graver par procédé de gravure "DRIE" le premier substrat, sur la face avant pour obtenir A, sur la face arrière pour obtenir A ;
c. graver par procédé de gravure "DRIE" le deuxième substrat, sur la face avant pour obtenir B, sur la face arrière pour obtenir B ; en alternative des opérations b et c on peut, sur le premier substrat et sur le deuxième substrat effectuer la gravure outre des deux couches en une fois, sans effectuer une gravure face avant et face arrière ;
d. effectuer l'assemblage « wafer à wafer » des deux substrats ou « pièce à pièce » des composants individuels, pour obtenir AABB. Le bon alignement des géométries est alors lié à la spécification de la machine de bonding « wafer à wafer » ou au process « pièce à pièce », de façon bien connue de l'homme du métier.

Pour un type de pivot ABAB :

a. utiliser deux substrats SOI standard à deux couches ;
b. graver par procédé de gravure "DRIE" le premier substrat, sur la face avant pour obtenir A, sur la face arrière pour obtenir B ;
c. graver par procédé de gravure "DRIE" le deuxième substrat, sur la face avant pour obtenir A, sur la face arrière pour obtenir B ;
d. effectuer l'assemblage « wafer à wafer » des deux substrats ou « pièce à pièce » des composants individuels, pour obtenir ABAB. Comme précédemment, Le bon alignement des géométries est lié à la spécification de la machine de bonding « wafer à wafer » ou au process « pièce à pièce ».

Bien d'autres variantes de procédé peuvent être mises en œuvre, selon le nombre de lames et l'équipement disponible.

Les méthodes standard de fabrication par gravure DRIE du silicium ne permettent pas encore de fabriquer facilement un pivot monolithique ayant plus de deux niveaux distincts. Il est donc plus facile fabriquer des pièces séparées qui sont ensuite assemblées. Toutefois, la sensibilité aux erreurs d'assemblage nécessite une précision supérieure au micromètre, pour obtenir les propriétés optimales d'isochronisme et/ou d'insensibilité aux positions. Afin de résoudre ce problème, il est nécessaire d'adopter une stratégie de fabrication qui est décrite ci-dessous.

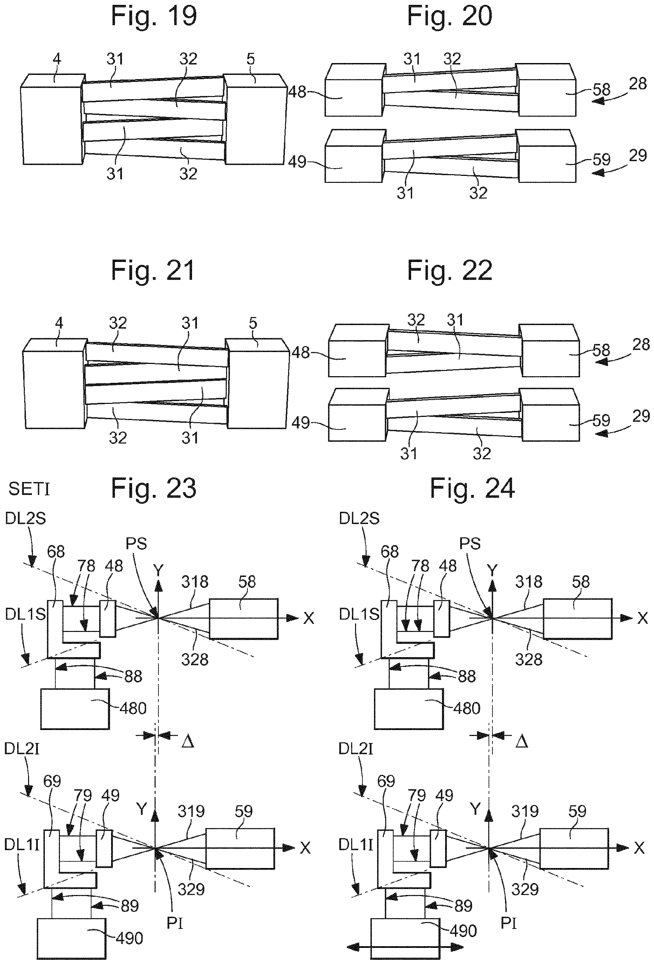

Dans une première démarche, il s'agit d'assembler avec une grande précision deux lames ayant des directions différentes. L'invention se propose de diviser le guidage flexible, ou pivot, en sous-unités composées de pivots à deux lames, par exemple une sous-unité supérieure et une sous-unité inférieure, dans le cas d'un guidage flexible comportant quatre lames, tel que visible sur la figure 19, avec quatre lames alternées, que l'on décompose en deux sous-unités de pivots à deux lames. Les figures 21 et 22 illustrent une décomposition similaire dans le cas de lames encadrées plutôt que de lames alternées. Chaque sous-unité est fabriquée par gravure DRIE à deux niveaux (wafer SOI attaqué par dessus et par dessous) afin de garantir une précision d'alignement suffisante.

La sous-unité supérieure est ensuite assemblée à la sous-unité inférieure.

Cet assemblage peut être effectué par toute méthode traditionnelle: goupillage d'alignement et vissage, ou collage, ou « wafer fusion bonding », ou soudure, ou brasure, ou toute autre méthode connue de l'homme du métier.

Le défaut d'assemblage se manifeste par un petit décalage Δ des axes de rotation des sous-unités supérieure et inférieure. De sorte que le mouvement de rotation du résonateur dicté par la sous-unité supérieure n'est pas en accord avec le mouvement de rotation dicté par la sous-unité inférieure. Pour éviter que ce décalage ne produise une sur-contrainte, le mécanisme comporte au moins une table de translation, dont le mouvement libre permet d'absorber le désaccord entre les deux rotations d'axes distincts. Au moins une des tables de translation doit être suffisamment souple pour que le désaccord de mouvement ne dégrade pas l'isochronisme. Dans le cas où l'on introduit deux tables de translation identiques, comme représenté dans la figure 23, elles doivent être suffisamment souples pour que le désaccord de mouvement ne dégrade pas l'isochronisme, et suffisamment rigides pour que la position du pivot soit bien déterminée. Les calculs montrent que ces conditions ne sont pas contradictoires si le décalage entre les axes de rotation est inférieur à 10 micromètres, ce qui est réalisable par assemblage traditionnel. Naturellement la précision d'un tel assemblage peut être améliorée avec des gravures complémentaires, de type tenon-mortaise, ou avec une pluralité d'assemblages tenon-mortaise faisant entre eux un angle non nul, ou tout autre agencement connu en mécanique de précision.

Plus particulièrement, tel que visible sur les figures, le mécanisme de guidage flexible 200 comporte, superposés l'un sur l'autre, au moins un étage supérieur 28 et au moins un étage inférieur 29.

La sous-unité supérieure comporte un étage supérieur 28, qui comporte, entre un support supérieur 48 et un élément inertiel supérieur 58, au moins une lame primaire supérieure 318 s'étendant selon une première direction de lame supérieure DL1S et une lame secondaire supérieure 328 s'étendant selon une deuxième direction de lame supérieure DL2S, croisées en projection en un point de croisement supérieur PS.

La sous-unité inférieure comporte un étage inférieur 29, qui comporte, entre un support inférieur 49 et un élément inertiel inférieur 59, au moins une lame primaire inférieure 319 s'étendant selon une première direction de lame inférieure DL1I et une lame secondaire inférieure 329 s'étendant selon une deuxième direction de lame inférieure DL2I croisées en projection en un point de croisement inférieur PI, distant au repos du point de croisement supérieur PS d'un écart Δ.

Et au moins l'étage supérieur 28 ou l'étage inférieur 29 comporte, entre la platine 900 et le support supérieur 48, ou respectivement le support inférieur 49, une table de translation supérieure 308, ou respectivement une table de translation inférieure 309, qui comporte au moins une liaison élastique qui autorise la translation selon un ou deux axes de liberté dans le plan d'oscillation, et dont la raideur en translation selon ces deux axes est inférieure à celle de chaque lame flexible 31, 32, 333, 34, 318, 319, 328, 329, que comporte le mécanisme de guidage flexible 200.

Notons que cette liaison élastique n'autorise pas les rotations d'axe parallèle à celui du résonateur.

On notera qu'il n'est pas nécessaire que les directions supérieures DL1S et DL2S de l'étage supérieur 28 soient identiques aux directions inférieures DL1I et DL2I de l'étage inférieur 29. De préférence, elles possèdent les mêmes bissectrices.

Plus particulièrement, le point P par lequel passe l'axe de rotation de l'élément inertiel 5 est situé entre le point de croisement supérieur PS et le point de croisement inférieur PI, exactement au milieu si le mécanisme de guidage flexible 200 comporte deux tables de translations supérieure 308 et inférieure 309 qui sont identiques. Dans une variante, ce point P est situé exactement sur le point de croisement inférieur PI si l'étage inférieur 29 ne possède pas de table de translation, ou sur le point de croisement supérieur PS si l'étage supérieur 28 ne possède pas de table de translation.

De préférence, l'oscillateur 100 comporte, pour chaque mécanisme de guidage flexible 200 qu'il comporte, un élément inertiel massif 5 est unique. Plus particulièrement, le mécanisme de guidage flexible 200 est unique, et l'élément inertiel massif 5 est unique.

Naturellement, la configuration préférée des tables de translation 308 et 309 illustrée par les figures n'est pas limitative. Ces tables de translation 308 et 309 peuvent aussi se trouver entre l'élément inertiel 5 et les encastrements du côté élément inertiel.

Si l'on définit par X et Y les axes des bissectrices des angles que font entre elles les projections des lames flexibles sur un plan parallèle commun, la combinaison des tables en translation, selon l'axe X et selon l'axe Y, doit être plus souple que le pivot flexible selon les mêmes axes. Cette règle est valable quel que soit le nombre d'étages, le cumul dû à la combinaison de toutes les tables, en translation, selon l'axe X et selon l'axe Y, doit être plus souple que le pivot flexible. La liaison élastique de la table de translation supérieure 308, ou respectivement de la table de translation inférieure 309, selon un ou deux axes de liberté dans le plan d'oscillation, est ainsi de préférence une liaison élastique selon ces axes X et Y.

Le stockage supplémentaire d'énergie élastique dans la ou les tables de translation, qui résulte du désaccord de mouvement, s'ajoute au stockage principal d'énergie du pivot, et tend à perturber l'isochronisme, sauf si la valeur du stockage supplémentaire est très inférieure à celle du stockage principal. C'est pourquoi les liaisons élastiques dans les tables de translation doivent être beaucoup plus souples que celles du pivot flexible.

Plus particulièrement, l'étage supérieur 28 et l'étage inférieur 29 comportent chacun, entre la platine 900 et le support supérieur 48, et respectivement le support inférieur 49, une table de translation supérieure 308, ou respectivement une table de translation inférieure 309, comportant au moins une liaison élastique selon un ou deux axes de liberté dans le plan d'oscillation, et dont la raideur est inférieure à celle de chaque lame flexible.

Quand il existe une table de translation par étage, elles ne sont pas nécessairement identiques entre elles.

Une variante consiste à utiliser deux tables de translation différentes, la première étant souple afin que le désaccord de mouvement ne dégrade pas l'isochronisme, et la seconde étant rigide afin d'assurer le positionnement du pivot.

Dans une autre variante, un étage peut comporter une table de translation, et l'autre étage avoir une fixation rigide

L'élément inertiel supérieur 58 et l'élément inertiel inférieur 59 constituent tout ou partie de l'élément inertiel massif 5, et sont rigidement liés, directement ou indirectement, entre eux. Le support supérieur 48 et le support inférieur 49 sont quant à eux, liés, selon le cas directement ou au travers d'une table de translation supérieure 308, ou respectivement une table de translation inférieure 309, à une partie rigide supérieure 480, respectivement une partie rigide inférieure 490, qui elles sont rigidement liées à l'élément support rigide 4, ou à la platine 900.

Les figures 23 et 24 montrent un exemple d'une telle liaison. Une table de translation supérieure 308 comporte, entre le support supérieur 48 et une masse intermédiaire supérieure 68, des premières liaisons élastiques souples 78 s'étendant selon la direction X, et, entre la masse intermédiaire supérieure 68 et la partie rigide supérieure 480, des deuxièmes liaisons élastiques souples 88 s'étendant selon la direction Y. De la même façon une table de translation inférieure 309 comporte, entre le support inférieur 49 et une masse intermédiaire inférieure 69, des premières liaisons élastiques souples 79 s'étendant selon la direction X, et, entre la masse intermédiaire inférieure 69 et la partie rigide inférieure 490, des deuxièmes liaisons élastiques souples 89 s'étendant selon la direction Y.

Ainsi, le mouvement de la table de translation, ou avantageusement des tables de translation, permet d'absorber le désaccord éventuel entre les rotations de la sous-unité supérieure et de la sous-unité inférieure. De plus, Chaque table de translation participe à la protection du mécanisme contre les fortes accélérations, lors d'une chute ou percussion par exemple.

On comprend que l'assemblage tel que décrit ci-dessus dans le cadre de la première démarche permet de rendre négligeable l'anisochronisme ajouté, à condition que le défaut d'assemblage Δ soit suffisamment petit.

A contrario, on peut décider d'exagérer volontairement le défaut d'assemblage Δ, afin d'introduire de l'anisochronisme de façon contrôlée, par exemple pour compenser un retard à l'échappement. Il est alors avantageux de rendre mobile, et réglable, au moins l'un des encastrements à la platine, c'est-à-dire le support supérieur 48 et/ou le support inférieur 49 dans le cas de la variante particulière non limitative illustrée. En effet, en ajustant la position relative de ces deux encastrements, on modifie la rigidité des tables de translation 308, 309, ce qui a pour effet de permettre le réglage de l'anisochronisme ajouté. Un tel réglage peut être effectué facilement avec la combinaison d'une gorge et d'un excentrique, ou par toute autre solution connue de l'horloger.

En somme, en déplaçant la position d'au moins un des encastrements à la platine, tel que visible sur la figure 24, il est possible d'ajuster l'anisochronisme produit par le défaut d'assemblage Δ.

Cet agencement particulier avec au moins une table de translation permet, en somme, de garantir l'alignement entre les étages supérieur et inférieur, et d'éviter les grandes contraintes que subiraient les lames si les étages supérieur et inférieur ne suivaient pas la même trajectoire.

Une autre alternative encore consiste à équiper le mécanisme avec une table de translation supérieure 308 et d'une table de translation inférieure 309, avec un support supérieur 48 et un support inférieur 49 qui ne sont plus rigidement liés à l'élément support rigide 4, ou à la platine 900, mais qui sont contraints à des mouvements plans, inverses en X et en Y, par une liaison de type vilebrequin ou similaire, par rapport à un axe fixe de l'élément support rigide 4, ou de la platine 900. Cette solution a l'avantage de permettre d'ajuster l'anisochronisme sans pour autant déplacer légèrement l'axe de rotation du résonateur.

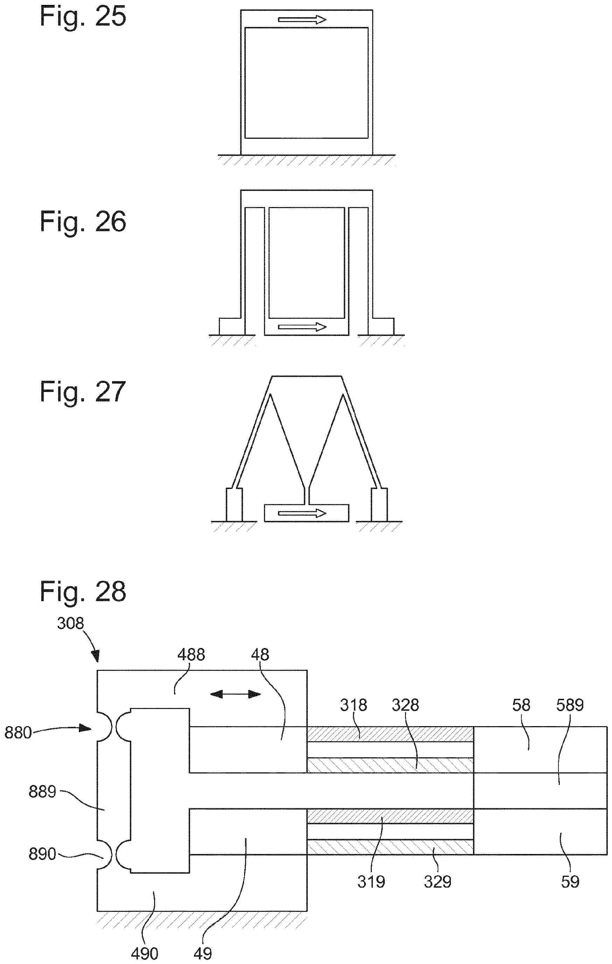

On comprend que les tables de translation, qui constituent des guidages flexibles en translation, peuvent être réalisées de bien des manières différentes. L'homme du métier en trouvera des exemples dans les références suivantes : [1] S.Henein, Conception des guidages flexibles. PPUR, [2] Larry L. Howell, Handbook of compliant mechanisms, WILEY), ou encore [3] Zeyi Wu and Qingsong Xu, Actuators 2018. De tels exemples non limitatifs sont illustrés aux figures 25 à 27.

La figure 28 illustre un exemple simplifié avec une table de translation avec liaison par cols : le support supérieur 48 est lié à un élément intermédiaire 488 suspendu par un premier col élastique 880 à un deuxième élément intermédiaire 889 à un deuxième col 890 qui effectue la liaison élastique avec la partie rigide inférieure 490, rigidement liée à la platine 900. Dans cet exemple l'élément inertiel supérieur 58 et l'élément inertiel inférieur 59 sont liés à un autre élément intermédiaire 589 pour constituer avec lui l'élément inertiel massif 5.

L'invention concerne ainsi un procédé de réalisation d'un mécanisme de guidage flexible 200 pour oscillateur mécanique 100 comportant au moins un élément inertiel 5 massif agencé pour osciller dans un plan d'oscillation, ce guidage flexible 200 comportant au moins deux premières lames flexibles 31, 32, s'étendant dans des plans parallèles ou confondus, et chacune de section sensiblement rectangulaire, et agencée pour être fixée ou encastrée sur un support fixe 4 et supporter cet élément inertiel 5, et agencées ensemble pour le rappeler vers une position de repos, selon lequel on effectue les etapes suivantes :

- (10) on détermine la géométrie du guidage flexible 200, on choisit le matériau des lames flexibles théoriques qu'il comporte, et on calcule le nombre et l'inclinaison des lames flexibles théoriques qu'il comporte ;
- (20) on calcule la longueur L entre encastrements, la hauteur H et l'épaisseur E de chaque lame flexible théorique;
- (30) on calcule le rapport d'aspect RA= H/E de chaque lame flexible théorique;
- (40) pour chaque lame flexible théorique; dont le rapport d'aspect RA calculé est supérieur ou égal à 10, on décompose cette lame flexible théorique en une pluralité de lames élémentaires incluses dans des niveaux superposés et chacune ayant un rapport d'aspect RA inférieur à 10, et on détermine le nombre de niveaux élémentaires de lames à superposer ;
- (50) on reprend le calcul des caractéristiques du guidage flexible 200 avec ces lames élémentaires, en substitution des lames flexibles théoriques, par itération, jusqu'à obtention de caractéristiques satisfaisantes;
- (60) on décompose le nombre de niveaux élémentaires en une pluralité de sous-unités 308, 309, chaque sous-unité étant, ou bien une sous-unité double comportant deux lames selon deux niveaux superposés et distantes selon deux plans parallèles, ou bien une sous-unité simple comportant une lame unique ;
- (70) on détermine, pour chaque sous-unité, un support élémentaire 48, 49, et un élément inertiel élémentaire 58, 59, que joignent les deux lames dans le cas d'une sous-unité double, ou que joint la lame unique dans le cas d'une sous-unité simple ;

- (80) on se munit, au moins pour chaque dite sous-unité double, d'un substrat SOI à deux niveaux dudit matériau, et on grave ce substrat par dessus et par dessous au moins quand la forme en projection des deux lames est distincte, et pour chaque sous-unité simple, d'un substrat SOI à un ou deux niveaux, qu'on grave, selon son épaisseur, d'un seul côté ou par-dessus et par-dessous, pour obtenir les différentes sous-unités constitutives du guidage flexible 200;
- (90) on assemble les uns sur les autres ces sous-unités formées de substrats gravés, en solidarisant tous leurs éléments inertiels élémentaires, et en fixant tous ces éléments inertiels élémentaires à l'élément inertiel 5, soit directement, soit par l'intermédiaire de tables de translation selon un ou deux degrés de liberté en translation dans le plan de chaque sous-unité, la raideur en translation de chaque table de translation étant inférieure à celle de chaque sous-unité ;
- (100) on fixe tous les supports élémentaires des sous-unités formées de substrats gravés au support fixe (4), soit directement, soit par l'intermédiaire de tables de translation selon un ou deux degrés de liberté en translation dans le plan de chaque sous-unité, la raideur en translation de chaque table de translation étant inférieure à celle de chaque sous-unité.

Dans une première variante, on calcule le guidage flexible 200 avec uniquement des lames théoriques coplanaires, parallèles et/ou divergentes.

Dans une deuxième variante, on calcule ce guidage flexible 200 avec uniquement des paires de lames croisées en projection, sur au moins deux niveaux différents et distinctes.

Dans une variante mixte, on calcule le guidage flexible 200 avec à la fois une premier groupe de lames théoriques coplanaires, parallèles et/ou divergentes, et un deuxième groupe de paires de lames croisées en projection, sur au moins deux niveaux différents et distinctes.

Plus particulièrement, quand on choisit des lames flexibles divergentes ou des d lames flexibles par paires croisées en projection, leur point de divergence ou leur point de croisement, en projection sur le plan d'oscillation, définit l'axe de pivotement virtuel de l'élément inertiel 5.

Plus particulièrement, dans la deuxième variante, quand on choisit des lames flexibles par paires croisées en projection, qui s'étendent à distance l'une de l'autre dans deux plans parallèles au plan d'oscillation de l'élément inertiel 5, et dont les projections des directions sur le plan d'oscillation se croisent au niveau d'un axe de pivotement virtuel O de l'élément inertiel 5 et définissent ensemble un premier angle $\alpha$ qui est l'angle au sommet, depuis cet axe de pivotement virtuel O, face auquel s'étend la partie du support fixe 4 qui est située entre les attaches des lames croisées sur le support fixe 4, on choisit ce premier angle $\alpha$ compris entre 70° et 74°. Plus particulièrement encore, on choisit ce premier angle $\alpha$ égal à 71,2°.

Toujours dans cette deuxième variante, on dimensionne avantageusement les lames flexibles avec un rayon intérieur ri qui est la distance entre l'axe de pivotement virtuel O et leur point d'attache sur l'élément de support fixe 4, avec un rayon extérieur re qui est la distance entre l'axe de pivotement virtuel O et leur point d'attache sur l'élément inertiel 5 et avec une longueur totale L avec L = ri + re, tels qu'un premier rapport Q tel que Q = ri/L, soit compris entre 0.12 et 0.13, ou tels qu'un deuxième rapport Qm tel que Qm =(ri+e/2)/(ri+e/2+re), soit compris entre 0.12 et 0.13. Plus particulièrement, on choisit ce premier rapport Q ou ce deuxième rapport Qm égal à 0,1264.

Avantageusement, quand on choisit des lames flexibles par paires croisées en projection, qui s'étendent à distance l'une de l'autre dans deux plans parallèles au plan d'oscillation de l'élément inertiel 5, et dont les projections des directions sur le plan d'oscillation se croisent au niveau d'un axe de pivotement virtuel O de l'élément inertiel 5, avec les encastrements des lames flexibles avec le support fixe 4 et l'élément inertiel 5 définissant deux directions de lames DL1, DL2, parallèles au plan d'oscillation, on réalise le mécanisme de guidage flexible 200 comportant, superposés l'un sur l'autre :

- au moins un étage supérieur 28 qui comporte, entre un support supérieur 48 et un élément inertiel supérieur 58, au moins une lame primaire supérieure 318 s'étendant selon une première direction de lame DL1 et une lame secondaire supérieure 328 s'étendant selon une deuxième direction de lame DL2 croisées en projection en un point de croisement supérieur PS,
- et au moins un étage inférieur 29 qui comporte, entre un support inférieur 49 et un élément inertiel inférieur 59, au moins une lame primaire inférieure 319 s'étendant selon une première direction de lame DL1 et une lame secondaire inférieure 329 s'étendant selon une deuxième direction de lame DL2 croisées en projection en un point de croisement inférieur PI ;

et on réalise cet étage supérieur 28 et/ou cet étage inférieur 29 comportant, entre d'une part le support fixe 4 et d'autre part le support supérieur 48, ou respectivement le support inférieur 49, et/ou entre d'une part l'élément inertiel 5 et d'autre part l'élément inertiel élémentaire supérieur 58, ou respectivement l'élément inertiel élémentaire inférieur 59,

une table de translation 308, 309, qui comporte au moins une liaison élastique selon un ou deux axes de liberté dans le plan d'oscillation, et dont la raideur en translation est inférieure à celle de chaque lame flexible.

Plus particulièrement, et tel que visible sur les figures 23 et 24, on réalise l'étage supérieur 28 et l'étage inférieur 29 comportant chacun, entre le support fixe 4 et le support supérieur 48, et respectivement le support inférieur 49, une table de translation 308, 309, comportant au moins une liaison élastique selon un ou deux axes de liberté dans le plan d'oscillation, et dont la raideur en translation est inférieure à celle de chaque lame flexible.

De façon particulière, on réalise la liaison élastique de la table de translation supérieure 308, ou respectivement de la table de translation inférieure 309, selon un ou deux axes de liberté dans le plan d'oscillation, sous la forme d'une liaison élastique selon les axes X et Y des bissectrices des angles que font entre elles les projections des lames flexibles du mécanisme de guidage flexible 200 sur le plan d'oscillation.

Dans une variante, on choisit des lames flexibles par paires croisées en projection, qui s'étendent à distance l'une de l'autre dans deux plans parallèles au plan d'oscillation de l'élément inertiel 5, et dont les projections des directions sur le plan d'oscillation se croisent au niveau d'un point de croisement P à proximité de l'axe de pivotement virtuel O de l'élément inertiel 5. Les encastrements des lames flexibles avec le support fixe 4 et l'élément inertiel 5 définissent deux directions de lames DL1, DL2, parallèles au plan d'oscillation. On réalise le mécanisme de guidage flexible 200 avec les deux directions de lames DL1, DL2, parallèles au plan d'oscillation et faisant entre elles, en position de repos, en projection sur le plan d'oscillation, un angle au sommet a, la position du point de croisement P étant définie par le rapport X= D/L où D est la distance entre la projection, sur le plan d'oscillation, de l'un des points d'encastrement des premières lames 31, 32, dans le support fixe 4 et le point de croisement P, et où L est la longueur totale de la projection, sur le plan d'oscillation, de la lame 31, 32, et avec le centre de masse de l'oscillateur 100 dans sa position de repos distant du point de croisement P d'un écart ε qui est compris entre 12% et 18% de la longueur totale L, avec la valeur du rapport D/L comprise entre 0 et 1, avec l'angle au sommet α inférieur ou égal à 60°, et avec, pour chaque première lame flexible 31, 32, le rapport d'encastrement D1/L1, D2/L2, compris entre 0.15 et 0.85, bornes comprises.

Dans l'une quelconque de ces variantes de procédé, il peut être avantageux de réaliser le guidage flexible 200 avec un premier nombre N1 de premières lames appelées lames primaires 31 s'étendant selon une première direction de lame DL1, et un deuxième nombre N2 de premières lames dites lames secondaires 32 s'étendant selon une deuxième direction de lame DL2, le premier nombre N1 et le deuxième nombre N2 étant chacun supérieur ou égal à deux. Cette disposition permet de limiter la hauteur des lames, ce qui est avantageux pour leur fonctionnement. Plus particulièrement, mais non nécessairement, on choisit le premier nombre N1 égal au deuxième nombre N2.

Plus particulièrement, on réalise le guidage flexible 200 avec au moins une paire formée d'une lame primaire 31 s'étendant selon une première direction de lame DL1, et d'une lame secondaire 32 s'étendant selon une deuxième direction de lame DL2, et avec, dans chaque paire, la lame primaire 31 identique à la lame secondaire 32 à l'orientation près. Plus particulièrement encore, on réalise le guidage flexible 200 ne comportant que des telles paires chacune formée d'une lame primaire 31 s'étendant selon une première direction de lame DL1, et d'une lame secondaire 32 s'étendant selon une deuxième direction de lame DL2, et avec, dans chaque paire, la lame primaire 31 identique à la lame secondaire 32 à l'orientation près.

De façon particulière, on réalise le guidage flexible 200 avec au moins un groupe de lames formé d'une lame primaire 31 s'étendant selon une première direction de lame DL1, et d'une pluralité de lames secondaires 32 s'étendant selon une deuxième direction de lame DL2, et avec, dans chaque groupe de lames, le comportement élastique de la lame primaire 31 identique au comportement élastique résultant de la pluralité de lames secondaires 32 à l'orientation près.

Dans une exécution particulière, on réalise le guidage flexible 200 avec un premier nombre de premières lames appelées lames primaires 31 s'étendant selon une première direction de lame DL1, et un deuxième nombre N2 de premières lames dites lames secondaires 32 s'étendant selon une deuxième direction de lame DL2, avec les deux directions de lames DL1, DL2, parallèles au plan d'oscillation et faisant entre elles, en position de repos, en projection sur ce plan d'oscillation, un angle au sommet a, les deux directions de lames DL1, DL2, se croisant, en projection sur le plan d'oscillation, en un point de croisement P dont la position est définie par le rapport X= D/L, où D est la distance entre la projection, sur le plan d'oscillation, de l'un des points d'encastrement des premières lames 31, 32, dans le support fixe 4 et le point de croisement P, et où L est la longueur totale de la projection, sur le plan d'oscillation, de la lame 31, 32, dans son élongation, et avec le rapport d'encastrement D1/L1, D2/L2, compris entre 0.15 et 0.49, bornes comprises, ou entre 0.51 et 0.85, bornes comprises. Plus particulièrement, on choisit l'angle au sommet (a) inférieur ou égal à 50°, et le rapport d'encastrement (D1/L1 ; D2/L2) compris entre 0.25 et 0.75, bornes comprises. Plus particulièrement, on choisit l'angle au sommet (a) inférieur ou égal à 40°, et le rapport d'encastrement (D1/L1 ; D2/L2) compris entre 0.30 et 0.70, bornes comprises. Plus particulièrement, on choisit l'angle au sommet (a) inférieur ou égal à 35°, et ledit rapport d'encastrement (D1/L1 ; D2/L2) compris entre 0.40 et 0.60, bornes comprises. Plus particulièrement, on choisit l'angle au sommet (a) inférieur ou égal à 30°.

Dans cette même variante où le rapport d'encastrement D1/L1, D2/L2, est compris entre 0.15 et 0.49, bornes comprises, ou entre 0.51 et 0.85, bornes comprises, plus particulièrement on choisit l'angle au sommet α et le rapport X= D/L satisfaisant la relation : h1(D/L) < a< h2(D/L), avec,
pour 0.2≤X<0.5 :

$$h1(X) = 116 - 473*(X + 0.05) + 3962*(X + 0.05)^3 - 6000*(X + 0.05)^4,$$

$$h2(X) = 128 - 473*(X - 0.05) + 3962*(X - 0.05)^3 - 6000*(X - 0.05)^4,$$

pour 0.5<X≤0.8:

.

$$h1(X) = 116 - 473*(1.05 - X) + 3962*(1.05 - X)^3 - 6000*(1.05 - X)^4,$$

$$h2(X) = 128 - 473*(0.95 - X) + 3962*(0.95 - X)^3 - 6000*(0.95 - X)^4.$$

Dans l'une quelconque de ces variantes de procédé, on réalise plus particulièrement le guidage flexible 200 avec un nombre total de lames flexibles strictement supérieur à deux.

Plus particulièrement, on réalise le guidage flexible 200 avec des lames flexibles droites et planes au repos. Plus particulièrement encore, on réalise le guidage flexible 200 avec toutes ses lames flexibles droites et planes au repos.

En somme, l'invention permet la réalisation de guidages flexibles pour oscillateurs de différentes géométries, avec des lames coplanaires : en vé, parallèles, ou autre, ou bien dans des plans décalés, notamment lames croisées en projection, ou autre. L'invention permet d'assurer le comportement régulier de ces lames sur toute leur plage d'utilisation, et donc de garantir l'isochronisme des oscillateurs conçus de façon adéquate et comportant de telles lames.

Naturellement, si l'invention s'applique de façon préférée à des guidages flexibles comportant plusieurs lames, et qui procurent les meilleurs résultats d'isochronisme, le procédé de réalisation est également applicable à des guidages comportant une lame unique.

## Revendications

1. Procédé de réalisation d'un mécanisme de guidage flexible (200) pour oscillateur mécanique (100) comportant au moins un élément inertiel (5) massif agencé pour osciller dans un plan d'oscillation, ledit guidage flexible (200) comportant au moins deux premières lames flexibles (31, 32) s'étendant dans des plans parallèles ou confondus et chacune de section sensiblement rectangulaire et agencée pour être fixée ou encastrée sur un support fixe (4) et supporter ledit élément inertiel (5), et agencées ensemble pour le rappeler vers une position de repos, selon lequel on effectue les étapes suivantes :

   - (10) on détermine la géométrie dudit guidage flexible (200), on choisit le matériau des lames flexibles théoriques qu'il comporte, et on calcule le nombre et l'inclinaison des lames flexibles théoriques qu'il comporte ;
   - (20) on calcule la longueur L entre encastrements, la hauteur H et l'épaisseur E de chaque dite lame flexible théorique;
   - (30) on calcule le rapport d'aspect RA= H/E de chaque dite lame flexible théorique;
   - (40) pour chaque dite lame flexible théorique, dont le rapport d'aspect RA calculé est supérieur ou égal à 10, on décompose cette lame flexible théorique en une pluralité de lames élémentaires incluses dans des niveaux superposés et chacune ayant un rapport d'aspect RA inférieur à 10, et on détermine le nombre de niveaux élémentaires de lames à superposer ;
   - (50) on reprend le calcul des caractéristiques dudit guidage flexible (200) avec lesdites lames élémentaires, en substitution desdites lames flexibles théoriques, jusqu'à obtention de caractéristiques satisfaisantes;
   - (60) on décompose ledit nombre de niveaux élémentaires en une pluralité de sous-unités (308, 309), chaque dite sous-unité étant, ou bien une sous-unité double comportant deux lames selon deux niveaux superposés et distantes selon deux plans parallèles, ou bien une sous-unité simple comportant une lame unique ;
   - (70) on détermine, pour chaque sous-unité, un support élémentaire (48, 49) et un élément inertiel élémentaire (58, 59) que joignent lesdites deux lames dans le cas d'une sous-unité double, ou que joint ladite lame unique dans le cas d'une sous-unité simple ;
   - (80) on se munit, au moins pour chaque dite sous-unité double, d'un substrat SOI à deux niveaux dudit matériau, et on grave ledit substrat par dessus et par dessous au moins quand la forme en projection desdites deux lames est distincte, et pour chaque sous-unité simple, d'un substrat SOI à un ou deux niveaux, qu'on grave, selon son épaisseur, d'un seul côté ou par-dessus et par-dessous, pour obtenir les différentes sous-unités constitutives dudit guidage flexible (200);

- (90) on assemble les uns sur les autres lesdites sous-unités formées de substrats gravés, en solidarisant tous leurs dits éléments inertiels élémentaires, et en fixant tous ces éléments inertiels élémentaires audit élément inertiel (5), soit directement, soit par l'intermédiaire de tables de translation selon un ou deux degrés de liberté en translation dans le plan de chaque dite sous-unité, la raideur en translation de chaque dite table de translation étant inférieure à celle de chaque dite sous-unité ;

- (100) on fixe tous les dits supports élémentaires desdites sous-unités formées de substrats gravés audit support fixe (4), soit directement, soit par l'intermédiaire de tables de translation selon un ou deux degrés de liberté en translation dans le plan de chaque dite sous-unité, la raideur en translation de chaque dite table de translation étant inférieure à celle de chaque dite sous-unité.

2. Procédé selon la revendication 1, **caractérisé en ce que** l'on calcule ledit guidage flexible (200) avec uniquement des lames théoriques coplanaires, parallèles et/ou divergentes.

3. Procédé selon la revendication 1, **caractérisé en ce que** l'on calcule ledit guidage flexible (200) avec uniquement des paires de lames croisées en projection, sur au moins deux niveaux différents et distinctes.

4. Procédé selon la revendication 1, **caractérisé en ce que** l'on calcule ledit guidage flexible (200) avec à la fois une premier groupe de lames théoriques coplanaires, parallèles et/ou divergentes, et un deuxième groupe de paires de lames croisées en projection, sur au moins deux niveaux différents et distinctes.

5. Procédé selon l'une des revendications 1 à 4, **caractérisé en ce que**, quand on choisit des dites lames flexibles divergentes ou des dites lames flexibles par paires croisées en projection, leur point de divergence ou leur point de croisement, en projection sur le plan d'oscillation, définit l'axe de pivotement virtuel dudit élément inertiel (5).

6. Procédé selon l'une des revendications 1 à 5, **caractérisé en ce que**, quand on choisit des dites lames flexibles par paires croisées en projection, qui s'étendent à distance l'une de l'autre dans deux plans parallèles au plan d'oscillation dudit élément inertiel (5), et dont les projections des directions sur ledit plan d'oscillation se croisent au niveau d'un axe de pivotement virtuel (O) dudit élément inertiel (5) et définissent ensemble un premier angle (a) qui est l'angle au sommet, depuis ledit axe de pivotement virtuel (O), face auquel s'étend la partie dudit support fixe (4) qui est située entre les attaches desdites lames croisées sur ledit support fixe (4), on choisit ledit premier angle compris entre 70° et 74°.

7. Procédé selon la revendication 6, **caractérisé en ce qu'**on choisit ledit premier angle (a) égal à 71,2°.

8. Procédé selon la revendication 6 ou 7, **caractérisé en ce qu'**on dimensionne lesdites lames flexibles avec un rayon intérieur (ri) qui est la distance entre ledit axe de pivotement virtuel (O) et leur point d'attache sur ledit élément de support fixe (4), avec un rayon extérieur (re) qui est la distance entre ledit axe de pivotement virtuel (O) et leur point d'attache sur ledit élément inertiel (5) et avec une longueur totale (L) avec L = ri + re, tels qu'un premier rapport (Q) tel que Q = ri/L, soit compris entre 0.12 et 0.13, ou tels qu'un deuxième rapport (Qm) tel que Qm =(ri+e/2)/(ri+e/2+re), soit compris entre 0.12 et 0.13.

9. Procédé selon la revendication 8, **caractérisé en ce qu'**on choisit ledit premier rapport (Q) ou ledit deuxième rapport (Qm) égal à 0,1264.

10. Procédé selon l'une des revendications 1 à 5, **caractérisé en ce que**, quand on choisit des dites lames flexibles par paires croisées en projection, qui s'étendent à distance l'une de l'autre dans deux plans parallèles au plan d'oscillation dudit élément inertiel (5), et dont les projections des directions sur ledit plan d'oscillation se croisent au niveau d'un axe de pivotement virtuel (O) dudit élément inertiel (5), avec les encastrements desdites lames flexibles avec ledit support fixe (4) et ledit élément inertiel (5) définissant deux directions de lames (DL1 ; DL2) parallèles audit plan d'oscillation, on réalise ledit mécanisme de guidage flexible (200) comportant, superposés l'un sur l'autre, au moins un étage supérieur (28) qui comporte, entre un support supérieur (48) et un élément inertiel supérieur (58), au moins une lame primaire supérieure (318) s'étendant selon une première direction de lame (DL1) et une lame secondaire supérieure (328) s'étendant selon une deuxième direction de lame (DL2) croisées en projection en un point de croisement supérieur (PS), et au moins un étage inférieur (29) qui comporte, entre un support inférieur

(49) et un élément inertiel inférieur (59), au moins une lame primaire inférieure (319) s'étendant selon une première direction de lame (DL1) et une lame secondaire inférieure (329) s'étendant selon une deuxième direction de lame (DL2) croisées en projection en un point de croisement inférieur (PI), et **en ce qu'**on réalise ledit étage supérieur (28) et/ou ledit étage inférieur (29) comportant, entre ledit support fixe (4) et ledit support supérieur (48), ou respectivement ledit support inférieur (49), et/ou entre ledit élément inertiel (5) et ledit élément inertiel élémentaire supérieur (58), ou respectivement ledit élément inertiel élémentaire inférieur (59), une table de translation (308 ; 309) comportant au moins une liaison élastique selon un ou deux axes de liberté dans le plan d'oscillation, et dont la raideur en translation est inférieure à celle de chaque dite lame flexible.

11. Procédé selon la revendication 10, **caractérisé en ce qu'**on réalise ledit étage supérieur (28) et ledit étage inférieur (29) comportant chacun, entre ledit support fixe (4) et ledit support supérieur (48), et respectivement ledit support inférieur (49), une table de translation (308 ; 309) comportant au moins une liaison élastique selon un ou deux axes de liberté dans le plan d'oscillation, et dont la raideur en translation est inférieure à celle de chaque dite lame flexible.

12. Procédé selon la revendication 10 ou 11, **caractérisé en ce qu'**on réalise ladite liaison élastique de ladite table de translation supérieure (308), ou respectivement de ladite table de translation inférieure (309), selon un ou deux axes de liberté dans ledit plan d'oscillation, sous la forme d'une liaison élastique selon les axes X et Y des bissectrices des angles que font entre elles les projections des lames flexibles dudit mécanisme de guidage flexible (200) sur ledit plan d'oscillation pour le cas à deux axes de liberté.

13. Procédé selon l'une des revendications 1 à 5, **caractérisé en ce que**, quand on choisit des dites lames flexibles par paires croisées en projection, qui s'étendent à distance l'une de l'autre dans deux plans parallèles au plan d'oscillation dudit élément inertiel (5), et dont les projections des directions sur ledit plan d'oscillation se croisent au niveau d'un point de croisement (P) à proximité de l'axe de pivotement virtuel (O) dudit élément inertiel (5), avec les encastrements desdites lames flexibles avec ledit support fixe (4) et ledit élément inertiel (5) définissant deux directions de lames (DL1 ; DL2) parallèles audit plan d'oscillation, on réalise ledit mécanisme de guidage flexible (200) avec lesdites deux directions de lames (DL1 ; DL2) parallèles audit plan d'oscillation et faisant entre elles, en position de repos, en projection sur ledit plan d'oscillation, un angle au sommet a, la position dudit point de croisement (P) étant définie par le rapport d'encastrement X= D/L où D est la distance entre la projection, sur ledit plan d'oscillation, de l'un des points d'encastrement desdites premières lames (31 ; 32) dans ledit support fixe (4) et ledit point de croisement (P), et où L est la longueur totale de la projection, sur ledit plan d'oscillation, de ladite lame (31 ; 32), et avec le centre de masse dudit oscillateur (100) dans sa position de repos distant dudit point de croisement (P) d'un écart (ε) qui est compris entre 12% et 18% de ladite longueur totale L, avec la valeur dudit rapport D/L comprise entre 0 et 1, avec ledit angle au sommet ($\alpha$) inférieur ou égal à 60°, et avec, pour chaque dite première lame flexible (31 ; 32), ledit rapport d'encastrement (D1/L1 ; D2/L2) compris entre 0.15 et 0.85, bornes comprises.

14. Procédé selon l'une des revendications 1 à 13, **caractérisé en ce qu'**on réalise ledit guidage flexible (200) avec un premier nombre N1 de dites premières lames appelées lames primaires (31) s'étendant selon une première direction de lame (DL1), et un deuxième nombre N2 de dites premières lames dites lames secondaires (32) s'étendant selon une deuxième direction de lame (DL2), ledit premier nombre N1 et ledit deuxième nombre N2 étant chacun supérieur ou égal à deux.

15. Procédé selon la revendication 14, **caractérisé en ce qu'**on choisit ledit premier nombre N1 égal audit deuxième nombre N2.

16. Procédé selon la revendication 14 ou 15, **caractérisé en ce qu'**on réalise ledit guidage flexible (200) avec au moins une paire formée d'une dite lame primaire (31) s'étendant selon une première direction de lame (DL1), et d'une dite lame secondaire (32) s'étendant selon une deuxième direction de lame (DL2), et avec, dans chaque paire, ladite lame primaire (31) identique à ladite lame secondaire (32) à l'orientation près.

17. Procédé selon la revendication 16, **caractérisé en ce qu'**on réalise ledit guidage flexible (200) ne comportant que des dites paires chacune formée d'une dite lame primaire (31) s'étendant selon une première direction de lame (DL1), et d'une dite lame secondaire (32) s'étendant selon une deuxième direction de lame (DL2), et avec, dans chaque paire, ladite lame primaire (31) identique à ladite lame secondaire (32) à l'orientation près.

18. Procédé selon la revendication 14, ou selon la revendication 16 selon la revendication 14, **caractérisé en ce que** on réalise ledit guidage flexible (200) avec au moins un groupe de lames formé d'une dite lame primaire (31) s'étendant selon une première direction de lame (DL1), et d'une pluralité de dite lames secondaires (32) s'étendant selon une deuxième direction de lame (DL2), et avec, dans chaque dit groupe de lames, le comportement élastique de ladite lame primaire (31) identique au comportement élastique résultant de ladite pluralité de lames secondaires (32) à l'orientation près.

19. Procédé selon l'une des revendications 1 à 18, **caractérisé en ce qu'**on réalise ledit guidage flexible (200) avec un premier nombre de dites premières lames appelées lames primaires (31) s'étendant selon une première direction de lame (DL1), et un deuxième nombre N2 de dites premières lames dites lames secondaires (32) s'étendant selon une deuxième direction de lame (DL2), avec lesdites deux directions de lames (DL1 ; DL2) parallèles audit plan d'oscillation faisant entre elles, en position de repos, en projection sur ledit plan d'oscillation, un angle au sommet a, lesdites deux directions de lames (DL1 ; DL2) se croisant, en projection sur ledit plan d'oscillation, en un point de croisement (P) dont la position est définie par le rapport d'encastrement X= D/L, où D est la distance entre la projection, sur ledit plan d'oscillation, de l'un des points d'encastrement desdites premières lames (31 ; 32) dans ledit support fixe (4) et ledit point de croisement (P), et où L est la longueur totale de la projection, sur ledit plan d'oscillation, de ladite lame (31 ; 32) dans son élongation, et avec ledit rapport d'encastrement (D1/L1 ; D2/L2) compris entre 0.15 et 0.49, bornes comprises, ou entre 0.51 et 0.85, bornes comprises.

20. Procédé selon la revendication 19, **caractérisé en ce qu'**on choisit ledit angle au sommet (a) inférieur ou égal à 50°, et ledit rapport d'encastrement (D1/L1 ; D2/L2) compris entre 0.25 et 0.75, bornes comprises.

21. Procédé selon la revendication 20, **caractérisé en ce qu'**on choisit ledit angle au sommet (a) inférieur ou égal à 40°, et ledit rapport d'encastrement (D1/L1 ; D2/L2) compris entre 0.30 et 0.70, bornes comprises.

22. Procédé selon la revendication 21, **caractérisé en ce qu'**on choisit ledit angle au sommet (a) inférieur ou égal à 35°, et ledit rapport d'encastrement (D1/L1 ; D2/L2) compris entre 0.40 et 0.60, bornes comprises.

23. Procédé selon l'une des revendications 19 à 22, **caractérisé en ce qu'**on choisit ledit angle au sommet (a) inférieur ou égal à 30°.

24. Procédé selon l'une des revendications 19 à 23, **caractérisé en ce qu'**on choisit ledit angle au sommet (a) et ledit rapport X= D/L satisfaisant la relation : h1(D/L) < a< h2(D/L), avec,
pour $0.2 \leq X < 0.5$ :

$$h1(X)= 116 - 473^*(X + 0.05) + 3962^*(X + 0.05)^3 - 6000^*(X + 0.05)^4,$$

$$h2(X)=128 - 473^*(X - 0.05) + 3962^*(X - 0.05)^3 - 6000^*(X - 0.05)^4,$$

pour $0.5 < X \leq 0.8$:

$$h1(X)= 116 - 473^*(1.05 - X) + 3962^*(1.05 - X)^3 - 6000^*(1.05 - X)^4,$$

$$h2(X)=128 - 473^*(0.95 - X) + 3962^*(0.95 - X)^3 - 6000^*(0.95 - X)^4.$$

25. Procédé selon l'une des revendications 1 à 24, **caractérisé en ce qu'**on réalise ledit guidage flexible (200) avec un nombre total de dites lames flexibles strictement supérieur à deux.

**Patentansprüche**

1. Verfahren zur Herstellung eines flexiblen Führungsmechanismus (200) für mechanischen Oszillator (100), der mindestens ein massives Trägheitselement (5) aufweist, das eingerichtet ist, um in einer Oszillationsebene zu oszillieren, wobei die flexible Führung (200) mindestens zwei erste flexible Lamellen (31, 32) aufweist, die sich in parallelen oder zusammenfallenden Ebenen erstrecken und jede etwa rechteckigen Querschnitts ist und eingerichtet, um auf einem festen Halter (4) befestigt oder eingebettet zu sein und das Trägheitselement (5) zu halten, und gemeinsam eingerichtet sind, um es gemeinsam in eine Ruhestellung zurückzustellen, wobei dazu die folgenden Schritte durchgeführt werden:

- (10) Bestimmen der Geometrie der flexiblen Führung (200), Auswählen des Materials der theoretischen flexiblen Lamellen, die sie aufweist, und Berechnen der Anzahl und der Neigung der theoretischen flexiblen Lamellen, die sie aufweist;
- (20) Berechnen der Länge L zwischen Einbettungen, der Höhe H und der Dicke E jeder theoretischen flexiblen Lamelle;
- (30) Berechnen des Seitenverhältnisses RA= H/E jeder theoretischen flexiblen Lamelle;
- (40) Zerlegen, für jede theoretische flexible Lamelle, deren berechnetes Seitenverhältnis RA größer oder gleich 10 ist, dieser theoretischen flexiblen Lamelle in eine Vielzahl elementarer Lamellen, die in übereinanderliegenden Niveaus einbezogen sind und jede ein Seitenverhältnis RA kleiner 10 hat, und Bestimmen der Anzahl elementarer Niveaus übereinanderzulegender Lamellen;
- (50) Fortsetzen der Berechnung der Merkmale der flexiblen Führung (200) mit den elementaren Lamellen als Ersatz der theoretischen flexiblen Lamellen bis zum Erhalt zufriedenstellender Merkmale;
- (60) Aufschlüsseln der Anzahl elementarer Niveaus in eine Vielzahl von Untereinheiten (308, 309), wobei jede Untereinheit entweder eine doppelte Untereinheit, die zwei Lamellen gemäß zwei übereinanderliegenden und beabstandeten Niveaus gemäß zwei parallelen Ebenen aufweist, oder eine einfache Untereinheit, die eine einzige Lamelle aufweist, ist;
- (70) Bestimmen, für jede Untereinheit, eines elementaren Halters (48, 49) und eines elementaren Trägheitselements (58, 59), die die zwei Lamellen im Fall einer doppelten Untereinheit verbinden oder die die einzige Lamelle im Fall einer einfachen Untereinheit verbindet;
- (80) sich Versehen, mindestens für jede doppelte Untereinheit, mit einem SOI-Substrat mit zwei Niveaus des Materials, und Gravieren des Substrats von oben und von unten mindestens, wenn die Projektionsform der zwei Lamellen unterschiedlich ist, und für jede einfache Untereinheit, mit einem SOI-Substrat mit einem oder zwei Niveaus, das je nach seiner Dicke auf einer Seite oder von oben und von unten graviert wird, um die verschiedenen Untereinheiten zu erhalten, aus denen die flexible Führung (200) besteht;
- (90) Montieren der einen auf den anderen der aus gravierten Substraten gebildeten Untereinheiten durch festes Verbinden aller ihrer elementaren Trägheitselemente und durch Befestigen aller dieser elementaren Trägheitselemente am Trägheitselement (5) entweder direkt oder über Translationstische gemäß einem oder zwei Translationsfreiheitsgraden in der Ebene jeder Untereinheit, wobei die Translationssteifigkeit jedes Translationstischs kleiner als die jeder Untereinheit ist;
- (100) Befestigen aller elementaren Halter der aus gravierten Substraten gebildeten gravierten Untereinheiten am festen Halter (4) entweder direkt oder über Translationstische gemäß einem oder zwei Translationsfreiheitsgraden in der Ebene jeder Untereinheit, wobei die Translationssteifigkeit jedes Translationstischs kleiner als die jeder Untereinheit ist.

2. Verfahren nach Anspruch 1, **dadurch gekennzeichnet, dass** die flexible Führung (200) nur mit koplanaren, parallelen und/oder divergierenden theoretischen Lamellen berechnet wird.

3. Verfahren nach Anspruch 1, **dadurch gekennzeichnet, dass** die flexible Führung (200) nur mit in Projektion gekreuzten Paaren von Lamellen auf mindestens zwei unterschiedlichen und verschiedenen Niveaus berechnet wird.

4. Verfahren nach Anspruch 1, **dadurch gekennzeichnet, dass** die flexible Führung (200) mit gleichzeitig einer ersten Gruppe theoretischer koplanarer, paralleler und/oder divergierender Lamellen und einer zweiten Gruppe in Projektion gekreuzter Paare von Lamellen auf mindestens zwei unterschiedlichen und verschiedenen Niveaus wird.

5. Verfahren nach einem der Ansprüche 1 bis 4, **dadurch gekennzeichnet, dass** bei der Auswahl der divergierenden flexiblen Lamellen oder der in Projektion gekreuzten Paare flexibler Lamellen deren Divergenzpunkt oder deren Kreuzungspunkt in Projektion auf der Oszillationsebene die virtuelle Drehachse des Trägheitselements (5) definiert.

6. Verfahren nach einem der Ansprüche 1 bis 5, **dadurch gekennzeichnet, dass** bei Auswahl der in Projektion gekreuzten Paare flexibler Lamellen, die sich voneinander beabstandet in zwei zur Oszillationsebene des Trägheitselements (5) parallelen Ebenen erstrecken und deren Ausrichtungsprojektionen auf die Oszillationsebene sich im Bereich einer virtuellen Drehachse (O) des Trägheitselements (5) kreuzen und gemeinsam einen ersten Winkel (a) definieren, der der Winkel an der Spitze ist, ab der virtuellen Drehachse (O), wo sich der Teil des festen Halters (4) gegenüber erstreckt, der sich zwischen den Befestigungen der gekreuzten Lamellen am festen Halter (4) befindet, der erste Winkel gewählt wird, der zwischen 70° und 74° liegt.

7. Verfahren nach Anspruch 6, **dadurch gekennzeichnet, dass** der erste Winkel (a) gleich 71,2° gewählt wird.

8. Verfahren nach Anspruch 6 oder 7, **dadurch gekennzeichnet, dass** die flexiblen Lamellen mit einem Innenradius (ri) dimensioniert werden, der der Abstand zwischen der virtuellen Drehachse (O) und ihrem Befestigungspunkt an dem festen Halterelement (4) ist, mit einem Außenradius (re), der der Abstand zwischen der virtuellen Drehachse (O) und ihrem Befestigungspunkt am Trägheitselement (5) ist und mit einer Gesamtlänge (L) mit L = ri + re, derart, dass ein erstes Verhältnis (Q) wie Q = ri/L zwischen 0,12 und 0,13 liegt oder derart, dass ein zweites Verhältnis (Qm) wie Qm =(ri+e/2)/(ri+e/2+re) zwischen 0,12 und 0,13 liegt.

9. Verfahren nach Anspruch 8, **dadurch gekennzeichnet, dass** das erste Verhältnis (Q) oder das zweite Verhältnis (Qm) gleich 0,1264 gewählt wird.

10. Verfahren nach einem der Ansprüche 1 bis 5, **dadurch gekennzeichnet, dass** bei Auswahl der in Projektion gekreuzten Paare flexibler Lamellen, die sich voneinander beabstandet in zwei zur Oszillationsebene des Trägheitselements (5) parallelen Ebenen erstrecken und deren Ausrichtungsprojektionen auf die Oszillationsebene sich im Bereich einer virtuellen Drehachse (O) des Trägheitselements (5) kreuzen, mit den Einbettungen der flexiblen Lamellen in den festen Halter (4) und das Trägheitselement (5), wodurch zwei Lamellenausrichtungen (DL1; DL2) definiert werden, die parallel zur Oszillationsebene sind, der flexible Führungsmechanismus (200) hergestellt wird, der übereinandergelagert mindestens eine obere Stufe (28) aufweist, die zwischen einem oberen Halter (48) und einem oberen Trägheitselement (58) mindestens eine obere primäre Lamelle (318) aufweist, die sich gemäß einer ersten Lamellenausrichtung (DL1) erstreckt, und eine obere sekundäre Lamelle (328), die sich gemäß einer zweiten Lamellenausrichtung (DL2) erstreckt, die sich in Projektion in einem oberen Kreuzungspunkt (PS) kreuzen, und mindestens eine untere Stufe (29), die zwischen einem unteren Halter (49) und einem unteren Trägheitselement (59) mindestens eine untere primäre Lamelle (319) aufweist, die sich gemäß einer ersten Lamellenausrichtung (DL1) erstreckt, und eine untere sekundäre Lamelle (329), die sich gemäß einer zweiten Lamellenausrichtung (DL2) erstreckt, die sich in Projektion in einem unteren Kreuzungspunkt (PI) kreuzen, und dass die obere Stufe (28) und/oder die untere Stufe (29) hergestellt werden, aufweisend zwischen dem festen Halter (4) und dem oberen Halter (48) oder beziehungsweise dem unteren Halter (49) und/oder zwischen dem Trägheitselement (5) und dem oberen elementaren Trägheitselement (58) oder beziehungsweise dem unteren elementaren Trägheitselement (59), einen Translationstisch (308; 309), der mindestens eine elastische Verbindung gemäß einer oder zwei Freiheitsachsen in der Oszillationsebene aufweist und dessen Translationssteifigkeit kleiner als die jeder flexiblen Lamelle ist.

11. Verfahren nach Anspruch 10, **dadurch gekennzeichnet, dass** die obere Stufe (28) und die untere Stufe (29) hergestellt werden, aufweisend jede zwischen dem festen Halter (4) und dem oberen Halter (48) und beziehungsweise dem unteren Halter (49), einen Translationstisch (308; 309), der mindestens eine elastische Verbindung gemäß einer oder zwei Freiheitsachsen in der Oszillationsebene aufweist und dessen Translationssteifigkeit kleiner als die jeder flexiblen Lamelle ist.

12. Verfahren nach Anspruch 10 oder 11, **dadurch gekennzeichnet, dass** die elastische Verbindung des oberen Translationstischs (308) oder beziehungsweise des unteren Translationstischs (309) gemäß einer oder zwei Freiheitsachsen in der Oszillationsebene in Form einer elastischen Verbindung gemäß den Achsen X und Y der Winkelhalbierenden hergestellt wird, die zwischen sich die Projektionen der flexiblen Lamellen des flexiblen Führungsmechanismus (200) auf der Oszillationsebene für den Fall mit zwei Freiheitsachsen bilden.

13. Verfahren nach einem der Ansprüche 1 bis 5, **dadurch gekennzeichnet, dass** bei Auswahl der in Projektion gekreuzten Paare flexibler Lamellen, die sich voneinander beabstandet in zwei zur Oszillationsebene des Trägheitselements (5) parallelen Ebenen erstrecken und deren Ausrichtungsprojektionen auf die Oszillationsebene sich im Bereich eines virtuellen Kreuzungspunkts (P) in der Nähe der virtuellen Drehachse (O) des Trägheitselements (5) kreuzen, mit den Einbettungen der flexiblen Lamellen in den festen Halter (4) und das Trägheitselement (5), wodurch zwei Lamellenausrichtungen (DL1; DL2) definiert werden, die parallel zur Oszillationsebene sind, der flexible Führungsmechanismus (200) mit den zwei Lamellenausrichtungen (DL1 ; DL2) hergestellt wird, die parallel zur Oszillationsebene sind und zwischen sich in Ruhestellung in Projektion auf die Oszillationsebene einen Winkel an der Spitze α bilden, wobei die Position des Kreuzungspunkts (P) durch das Einbettungsverhältnis X= D/L definiert ist, wobei D der Abstand zwischen der Projektion auf die Oszillationsebene von dem einen der Einbettungspunkte der ersten Lamellen (31; 32) in den festen Halter (4) und dem Kreuzungspunkt (P) ist, und wobei L die Gesamtlänge der Projektion auf die Oszillationsebene der Lamelle (31; 32) ist, und mit dem Massenzentrum des Oszillators (100) in seiner Ruhestellung, das vom Kreuzungspunkt (P) in einem Abstand (ε) beabstandet ist, der zwischen 12 % und 18 % der Gesamtlänge L beträgt, mit dem Wert des Verhältnisses D/L, das zwischen 0 und 1 liegt, mit dem Winkel an der Spitze (a) kleiner oder gleich 60°, und mit, für jede erste flexible Lamelle (31; 32), dem Einbettungsverhältnis (D1/L1 ; D2/L2), das zwischen 0,15 und 0,85 liegt, Grenzwerte eingeschlossen.

14. Verfahren nach einem der Ansprüche 1 bis 13, **dadurch gekennzeichnet, dass** die flexible Führung (200) mit einer ersten Anzahl N1 erster Lamellen, bezeichnet als primäre Lamellen (31), die sich gemäß einer ersten Lamellenausrichtung (DL1) erstrecken, und einer zweiten Anzahl N2 erster Lamellen, bezeichnet als sekundäre Lamellen (32), die sich gemäß einer zweiten Lamellenausrichtung (DL2) erstrecken, hergestellt wird, wobei die erste Anzahl N1 und die zweite Anzahl N2 jeweils größer oder gleich zwei ist.

15. Verfahren nach Anspruch 14, **dadurch gekennzeichnet, dass** die erste Anzahl N1 gleich der zweiten Anzahl N2 gewählt wird.

16. Verfahren nach Anspruch 14 oder 15, **dadurch gekennzeichnet, dass** die flexible Führung (200) mit mindestens einem Paar hergestellt wird, das von einer primären Lamelle (31) gebildet ist, die sich gemäß einer ersten Lamellenausrichtung (DL1) erstreckt, und einer sekundären Lamelle (32), die sich gemäß einer zweiten Lamellenausrichtung (DL2) erstreckt, und mit, in jedem Paar, der primären Lamelle (31) identisch mit der sekundären Lamelle (32), mit Ausnahme der Ausrichtung.

17. Verfahren nach Anspruch 16, **dadurch gekennzeichnet, dass** die flexible Führung (200) mit nur Paaren aufweisend hergestellt wird, von denen jedes von einer primären Lamelle (31) gebildet ist, die sich gemäß einer ersten Lamellenausrichtung (DL1) erstreckt, und einer sekundären Lamelle (32), die sich gemäß einer zweiten Lamellenausrichtung (DL2) erstreckt, und mit, in jedem Paar, der primären Lamelle (31) identisch mit der sekundären Lamelle (32), mit Ausnahme der Ausrichtung.

18. Verfahren nach Anspruch 14 oder nach Anspruch 16 nach Anspruch 14, **dadurch gekennzeichnet, dass** die flexible Führung (200) mit mindestens einer Lamellengruppe hergestellt wird, die von einer primären Lamelle (31) gebildet ist, die sich gemäß einer ersten Lamellenausrichtung (DL1) erstreckt, und einer Vielzahl sekundärer Lamellen (32), die sich gemäß einer zweiten Lamellenausrichtung (DL2) erstrecken, und mit, in jeder Lamellengruppen, dem elastischen Verhalten der primären Lamelle (31) identisch mit dem elastischen Verhalten resultierend aus der Vielzahl sekundärer Lamellen (32), mit Ausnahme der Ausrichtung.

19. Verfahren nach einem der Ansprüche 1 bis 18, **dadurch gekennzeichnet, dass** die flexible Führung (200) mit einer ersten Anzahl erster Lamellen, bezeichnet als primäre Lamellen (31), die sich gemäß einer ersten Lamellenausrichtung (DL1) erstrecken, und einer zweiten Anzahl N2 erster Lamellen, bezeichnet als sekundäre Lamellen (32), die sich gemäß einer zweiten Lamellenausrichtung (DL2) erstrecken, hergestellt wird, mit den zwei Lamellenausrichtungen (DL1; DL2), die parallel zur Oszillationsebene sind, die zwischen sich in Ruhestellung in Projektion auf die Oszillationsebene einen Winkel an der Spitze $\alpha$ bilden, wobei sich die zwei Lamellenausrichtungen (DL1 ; DL2) in Projektion auf die Oszillationsebene in einem Kreuzungspunkt (P) kreuzen, dessen Position durch das Einbettungsverhältnis X= D/L definiert ist, wobei D der Abstand zwischen der Projektion auf die Oszillationsebene von dem einen der Einbettungspunkte der ersten Lamellen (31; 32) in den festen Halter (4) und dem Kreuzungspunkt (P) ist, und wobei L die Gesamtlänge der Projektion auf die Oszillationsebene der Lamelle (31; 32) in ihrer Längenausdehnung ist, und mit dem Einbettungsverhältnis (D1/L1; D2/L2), das zwischen 0,15 und 0,49 liegt, Grenzwerte eingeschlossen, oder zwischen 0,51 und 0,85, Grenzwerte eingeschlossen.

20. Verfahren nach Anspruch 19, **dadurch gekennzeichnet, dass** der Winkel an der Spitze (a) kleiner oder gleich 50° gewählt wird und das Einbettungsverhältnis (D1/L1 ; D2/L2) zwischen 0,25 und 0,75 liegt, Grenzwerte eingeschlossen.

21. Verfahren nach Anspruch 20, **dadurch gekennzeichnet, dass** der Winkel an der Spitze (a) kleiner oder gleich 40° gewählt wird und das Einbettungsverhältnis (D1/L1 ; D2/L2) zwischen 0,30 und 0,70 liegt, Grenzwerte eingeschlossen.

22. Verfahren nach Anspruch 21, **dadurch gekennzeichnet, dass** der Winkel an der Spitze (a) kleiner oder gleich 35° gewählt wird, und das Einbettungsverhältnis (D1/L1 ; D2/L2) zwischen 0,40 und 0,60 liegt, Grenzwerte eingeschlossen.

23. Verfahren nach einem der Ansprüche 19 bis 22, **dadurch gekennzeichnet, dass** der Winkel an der Spitze (a) kleiner oder gleich 30° gewählt wird.

**24.** Verfahren nach einem der Ansprüche 19 bis 23, **dadurch gekennzeichnet, dass** der Winkel an der Spitze (a) und das Verhältnis X= D/L, das die Relation h1 (D/L) < a< h2(D/L) erfüllt, gewählt wird mit für $0,2 \leq X < 0,5$:

$$h1(X) = 116 - 473^*(X + 0,05) + 3962^*(X + 0,05)^3 - 6000^*(X + 0,05)^4,$$

$$h2(X) = 128 - 473^*(X + 0,05) + 3962^*(X + 0,05)^3 - 6000^*(X + 0,05)^4,$$

für $0,5 < X \leq 0,8$:

$$h1(X) = 116 - 473^*(1,05 - X) + 3962^*(1,05 - X)^3 - 6000^*(1,05 - X)^4,$$

$$h2(X) = 128 - 473^*(0,95 - X) + 3962^*(0,95 - X)^3 - 6000^*(0,95 - X)^4.$$

**25.** Verfahren nach einem der Ansprüche 1 bis 24, **dadurch gekennzeichnet, dass** die flexible Führung (200) mit einer Gesamtanzahl flexibler Lamellen strikt größer als zwei hergestellt wird.


**Claims**

**1.** Method for making a flexure bearing mechanism (200) for a mechanical oscillator (100) including at least one solid inertial element (5) arranged to oscillate in an oscillation plane, said flexure bearing (200) including at least two first flexible strips (31,32) which extend in parallel or coincident planes and are each of substantially rectangular cross section and arranged to be fixed to or embedded in a stationary support (4) and to support said solid inertial element (5) and together arranged to return said inertial element to a rest position, wherein the following steps are performed:

- (10) determining the geometry of said flexure bearing (200), choosing the material of the theoretical flexible strips comprised therein, and calculating the number and inclination of the flexible strips comprised therein;
- (20) calculating the length L between embedding points, the height H and thickness E of each said theoretical flexible strip;
- (30) calculating the aspect ratio RA= H/E of each said theoretical flexible strip;
- (40) for each said theoretical flexible strip, wherein the aspect ratio RA calculated is greater than or equal to 10, breaking down said theoretical flexible strip into a plurality of basic strips contained in superposed levels and each having an aspect ratio RA of less than 10, and determining the number of basic levels of strips to be superposed;
- (50) repeating the calculation of the characteristics of said flexure bearing (200) with said basic strips, in place of the theoretical flexible strips, until satisfactory characteristics are obtained;
- (60) breaking down said number of basic levels into a plurality of sub-units (308, 309), each said sub-unit being either a double sub-unit including two strips on two superposed and remote levels in two parallel planes, or a single sub-unit having only one strip;
- (70) determining, for each sub-unit, a basic support (48, 49), and a basic inertial element (58, 59), which are joined by said two strips in the case of a double sub-unit, or which are joined by said single strip in the case of a single sub-unit;
- (80) providing, at least for each double sub-unit, an SOI substrate with two levels of said material, and etching said substrate on both sides at least when the projected shape of said two strips is different, and for each single sub-unit, one SOI substrate with one or two levels, which is etched, depending on its thickness, on one side or on both sides, to obtain the various sub-units that form said flexure bearing (200);
- (90) assembling said sub-units formed of etched substrates one atop the other, by joining all their basic inertial elements, and fixing all said basic inertial elements to said inertial element (5), either directly, or via translational tables along one or two translational degrees of freedom in the plane of each said sub-unit, the translational stiffness of each said translational table being lower than that of each said sub-unit;
- (100) fixing all said basic supports of said sub-units formed of etched substrates to said stationary support (4), either directly, or via translational tables along one or two translational degrees of freedom in the plane of each said sub-unit, the translational stiffness of each said translational table being lower than that of each said sub-unit.

2. Method according to claim 1, **characterized in that** said flexure bearing (200) is calculated with only coplanar, parallel and/or divergent theoretical strips.

3. Method according to claim 1, **characterized in that** said flexure bearing (200) is calculated with only pairs of strips that cross in projection, on at least two different and distinct levels.

4. Method according to claim 1, **characterized in that** said flexure bearing (200) is calculated with both a first group of coplanar, parallel and/or divergent theoretical strips, and a second group of pairs of strips that cross in projection, on at least two different and distinct levels.

5. Method according to any of claims 1 to 4, **characterized in that**, when said flexible strips are chosen to be divergent strips or said flexible strips in pairs that cross in projection, their point of divergence or crossing point, in projection onto the oscillation plane, defines the virtual pivot axis of said inertial element (5).

6. Method according to any of claims 1 to 5, **characterized in that**, when said strips are chosen to be strips in pairs that cross in projection, which extend at a distance from each other in two planes parallel to the oscillation plane of said inertial element (5), and whose projected directions onto said oscillation plane intersect at a virtual pivot axis (O) of said inertial element (5) and together define a first angle ($\alpha$) which is the vertex angle, from said virtual pivot axis (O), opposite which extends the part of said stationary support (4) that is located between the attachments of said crossed strips to said stationary support (4), said first angle is chosen to be comprised between 70° and 74°.

7. Method according to claim 6, **characterized in that** said first angle ($\alpha$) is chosen to be equal to 71.2°.

8. Method according to claim 6 or 7, **characterized in that** said flexible strips are dimensioned with an internal radius (ri) which is the distance between said virtual pivot axis (O) and the point of attachment of said strips to said stationary support (4), with an external radius (re) which is the distance between said virtual pivot axis (O) and point of attachment of said strips to said inertial element (5) and with a total length (L) where L = ri + re, such that a first ratio (Q) such that Q = ri/L, is comprised between 0.12 et 0.13, or such that a second ratio (Qm) such that Qm =(ri+e/2)/(ri+e/2+re), is comprised between 0.12 et 0.13.

9. Method according to claim 8, **characterized in that** said first ratio (Q) or said second ratio (Qm) is chosen to be equal to 0.1264.

10. Method according to any of claims 1 to 5, **characterized in that**, when said strips are chosen to be strips in pairs that cross in projection, which extend at a distance from each other in two planes parallel to the oscillation plane of said inertial element (5), and whose projected directions onto said oscillation plane intersect at a virtual pivot axis (O) of said inertial element (5), with the embedding points of said flexible strips in said stationary support (4) and said inertial element (5) defining two strip directions (DL1; DL2) parallel to said oscillation plane, said flexure bearing mechanism (200) including, superposed on each other, at least one upper level (28), which includes, between an upper support (48) and an upper inertial element (58), at least one upper primary strip (318) extending in a first strip direction (DL1) and one upper secondary strip (328) extending in a second strip direction (DL2), crossed in projection at an upper crossing point (PS), and at least one lower level (29), which includes, between a lower support (49) and a lower inertial element (59), at least one lower primary strip (319) extending in a first strip direction (DL1) and one lower secondary strip (329) extending in a second strip direction (DL2), crossed in projection at a lower crossing point (PI), and **in that** said upper level (28) and/or said lower level (29) is made to include, between said stationary support (4) and said upper support (48), or respectively said lower support (49), and/or between said inertial element (5) and said upper basic inertial element (58), or respectively said lower basic inertial element (59), a translational table (308, 309), comprising at least one elastic connection along one or two axes of freedom in the oscillation plane, and whose translational stiffness is lower than that of each said flexible strip.

11. Method according to claim 10, **characterized in that** said upper level (28) and said lower level (29) are each made to include, between said stationary support (4) and said upper support (48), and respectively said lower support (49), a translational table (308; 309) comprising at least one elastic connection along one or two axes of freedom in the oscillation plane, and whose translational stiffness is lower than that of each said flexible strip.

12. Method according to claim 10 or 11, **characterized in that** said elastic connection of said upper translational table (308) or respectively of said lower translational table (309), along one or two axes of freedom in the oscillation plane, is made in the form of an elastic connection along the axes X and Y of the bissectors of the angles formed between the projections of the flexible strips of said flexure bearing mechanism (200) onto said oscillation plane in the case of two axes of freedom.

13. Method according to any of claims 1 to 5, **characterized in that**, when said strips are chosen to be strips in pairs that cross in projection, which extend at a distance from each other in two planes parallel to the oscillation plane of said inertial element (5), and whose projected directions onto said oscillation plane intersect at a crossing point (P) in proximity to the virtual pivot axis (O) of said inertial element (5), with the embedding points of said flexible strips in said stationary support (4) and said inertial element (5) defining two strip directions (DL1; DL2) parallel to said oscillation plane, said flexure bearing mechanism (200) is made with said two strip directions (DL1, DL2) parallel to said oscillation plane and forming therebetween, in the rest position, in projection onto the oscillation plane, a vertex angle ($\alpha$), the position of said crossing point (P) being defined by the embedding point ratio X= D/L, where D is the distance between the projection onto said oscillation plane of one of the embedding points of said first strips (31; 32) in said stationary support (4) and said crossing point (P), and wherein L is the total projected length, onto said oscillation plane, of said strip (31, 32), and with the centre of mass of said oscillator (100) in its rest position, separated from said crossing point (P) by a distance ($\varepsilon$) which is comprised between 12% and 18% of said total length L, with the value of said ratio D/L comprised between 0 and 1, with said vertex angle ($\alpha$) less than or equal to 60° and, for each said first flexible strip (31, 32), with said embedding point ratio (D1/L1, D2/L2) comprised between 0.15 and 0.85 inclusive.

14. Method according to any of claims 1 to 13, **characterized in that** said flexure bearing (200) is made with a first number N1 of first said strips, called primary strips (31), extending in a first strip direction (DL1), and a second number N2 of said first strips called secondary strips (32) extending in a second strip direction (DL2), said first number N1 and said second number N2 each being greater than or equal to two.

15. Method according to claim 14, **characterized in that** said first number N1 is chosen to be equal to said second number N2.

16. Method according to claim 14 or 15, **characterized in that** said flexure bearing (200) is made with at least one pair formed of one said primary strip (31) extending in a first strip direction (DL1), and one said secondary strip (32) extending in a second strip direction (DL2) and, in each pair, said primary strip (31) is identical to said secondary strip (32), except as regards orientation.

17. Method according to claim 16, **characterized in that** said flexure bearing (200) is made to include only said pairs each formed of one said primary strip (31) extending in a first strip direction (DL1), and one said secondary strip (32) extending in a second strip direction (DL2) and, in each pair, said primary strip (31) is identical to said secondary strip (32), except as regards orientation.

18. Method according to claim 14, or according to claim 16 according to claim 14, **characterized in that** said flexure bearing (200) is made with at least one group of strips formed of a said primary strip (31) extending in a first strip direction (DL1), and a plurality of said secondary strips (32) extending in a second strip direction (DL2) and, in each said group of strips, the elastic behaviour of said primary strip (31) is identical to the elastic behaviour resulting from said plurality of secondary strips (32), except as regards orientation.

19. Method according to any of claims 1 to 18, **characterized in that** said flexure bearing (200) is made with a first number of said first strips called primary strips (31) extending in a first strip direction (DL1), and a second number N2 of said first strips called secondary strips (32) extending in a second strip direction (DL2), with said strip directions (DL1, DL2) parallel to said oscillation plane forming therebetween, in a rest position, in projection onto said oscillation plane, a vertex angle $\alpha$, said two strip directions (DL1, DL2) intersecting, in projection onto said oscillation plane, at a crossing point (P) whose position is defined by the embedding point ratio X= D/L, where D is the distance between the projection onto said oscillation plane of one of the embedding points of said first strips (31; 32) in said stationary support (4) and said crossing point (P), and where L is the total projected length onto the oscillation plane of said strip (31, 32) in its elongation, and where the embedding point ratio (D1/L1, D2/L2) is comprised between 0.15 et 0.49 inclusive, or between 0.51 et 0.85 inclusive.

20. Method according to claim 19, **characterized in that** said vertex angle ($\alpha$) is chosen to be less than or equal to 50°, and said embedding point ratio (D1/L1; D2/L2) to be comprised between 0.40 and 0.75 inclusive.

21. Method according to claim 20, **characterized in that** the vertex angle ($\alpha$) is chosen to be less than or equal to 40° and said embedding point ratio (D1/L1, D2/L2) to be comprised between 0.40 and 0.70 inclusive.

22. Method according to claim 21, **characterized in that** the vertex angle ($\alpha$) is chosen to be less than or equal to 35° and said embedding ratio (D1/L1, D2/L2) to be comprised between 0.40 and 0.60 inclusive.

23. Method according to any of claims 19 to 22, **characterized in that** said vertex angle ($\alpha$) is chosen to be less than or equal to 30°.

24. Method (100) according to any of claims 19 to 23, **characterized in that** said apex angle ($\alpha$) and said ratio X= D/L satisfy the relation h1 (D/L) < $\alpha$< h2(D/L), where,
for $0.2 \leq X < 0.5$:

$$h1(X) = 116 - 473^*(X + 0.05) + 3962^*(X + 0.05)^3 - 6000^*(X + 0.05)^4,$$

$$h2(X) = 128 - 473^*(X - 0.05) + 3962^*(X - 0.05)^3 - 6000^*(X - 0.05)^4,$$

for $0.5 < X \leq 0.8$:

$$h1(X) = 116 - 473^*(1.05 - X) + 3962^*(1.05 - X)^3 - 6000^*(1.05 - X)^4,$$

$$h2(X) = 128 - 473^*(0.95 - X) + 3962^*(0.95 - X)^3 - 6000^*(0.95 - X)^4.$$

25. Method according to any of claims 1 to 24, **characterized in that** said flexure bearing (200) is made with a total number of said flexible strips strictly greater than two.

Fig. 1

Fig. 2

Fig. 3

## Fig. 4

## Fig. 5

## Fig. 9

Fig. 6

Fig. 7

Fig. 8

Fig. 10

Fig. 11

Fig. 12

Fig. 13

Fig. 14

Fig. 15

Fig. 16

Fig. 17

Fig. 18

# Fig. 19

# Fig. 20

# Fig. 21

# Fig. 22

# Fig. 23

# Fig. 24

Fig. 25

Fig. 26

Fig. 27

Fig. 28

# Fig. 29

```
  ┌──────┐
  │  10  │◄─────┐
  └──────┘      │
      │         │
      ▼         │
  ┌──────┐      │
  │  20  │      │
  └──────┘      │
      │         │
      ▼         │
  ┌──────┐      │
  │  30  │      │
  └──────┘      │
      │         │
      ▼         │
  ┌──────┐      │
  │  40  │      │
  └──────┘      │
      │         │
      ▼         │
  ┌──────┐      │
  │  50  │──────┘
  └──────┘
      │
  ┌──────┐
  │  60  │
  └──────┘
      │
  ┌──────┐
  │  70  │
  └──────┘
      │
┌──────────────┐
│   ┌──────┐   │
│   │  a   │   │
│   └──────┘   │
│   ┌──────┐   │
│   │  b   │   │───80
│   └──────┘   │
│   ┌──────┐   │
│   │  c   │   │
│   └──────┘   │
│   ┌──────┐   │
│   │  d   │   │
│   └──────┘   │
└──────────────┘
      │
  ┌──────┐
  │  90  │
  └──────┘
      │
  ┌──────┐
  │ 100  │
  └──────┘
```

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1419039 A
- EP 16155039 A
- EP 3035127 A1
- US 3628781 A
- EP 2911012 A1
- EP 2998800 A2
- DE 102016014001 A1
- EP 3326963 A
- EP 3130966 A1
- CH 709536 A2
- EP 17183666 A
- WO 2016124436 A1

**Littérature non-brevet citée dans la description**

- **M. H. KAHROBAIYAN.** *Congrès de Chronométrie de Montreux,* 28 Septembre 2016
- **LARRY L. HOWELL.** Handbook of compliant mechanisms. WILEY